# EUROPEAN PATENT APPLICATION

(11) **EP 4 580 335 A1**
(43) Date of publication of application: **02.07.2025**
(21) Application number: 24216122.2
(22) Date of filing: 28.11.2024
(51) Int. Cl.: H10D 30/01, H10D 30/00, H10D 62/13, H10D 64/23, B82Y 10/00

(54) **BACKSIDE CONTACT PLACEHOLDER FORMATION WITH IMPROVED PROCESS CONTROL**

(30) Priority: 29.12.2023 US 202318400913
(71) Applicant: Intel Corporation, Santa Clara, CA 95054 (US)
(72) Inventor: SENARATNE, Charutha, Hillsboro, OR 97124 (US); MILLS, Shaun, Hillsboro, OR 97123 (US); DUAN, Niangao, Portland, OR 97229 (US); SAUNDERS, Joseph, Portland, OR 97229 (US); PELLEGREN, James, Portland, OR 97125 (US); SMITH, Angeline, Hillsboro, OR 97124 (US); KRIST, Brian, Hillsboro, OR 97124 (US)
(74) Representative: HGF

(57) **Abstract**

Devices, transistor structures, systems, and techniques are described herein related to backside contacts for nanoribbon field effect transistors formed using a backside placeholder contact. The device comprises source/drain regions (1101 and 1102), nanoribbon channels (203), a gate (206), as well as back-and front-side metallizations (1301, M0-M4, BM0-BM2). The backside placeholder contact is templated from a recessed dielectric material such as a recessed carbon hardmask. The recessed dielectric material is formed and replaced with a placeholder metal in frontside processing, and the placeholder metal is revealed and replaced from the transistor backside to form the backside contact. The interface between the backside contact (1501) and the source/drain region (1101) has a concave shape, curved inwardly in the source/drain region with a flat peripheral part, as shown in the inset.

## Description

### BACKGROUND

Higher performance, lower cost, increased miniaturization, and greater density of integrated circuits (ICs) are ongoing goals of the electronics industry. To maintain the pace of increasing transistor density, for example, device dimensions must continue to shrink and/or new device structures are needed. In particular, gate-all-around (GAA), nanoribbon, and other advanced transistor structures provide gate materials that surround channel regions for improved performance. Furthermore, backside power delivery or, more generally, backside contacts to transistor source and drain structures, can reduce resistance, move contacts to the backside for increased transistor density, and offer other advantages.

However, deployment of GAA or nanoribbon transistors and backside contacts face numerous difficulties including problems associated with controlling the dimensions of backside contact placeholder materials. For example, the backside contact placeholders, which are formed during frontside transistor fabrication processing, are later accessed from the device backside, and replaced with contact metal. Current techniques for fabricating the backside contact placeholders include a metal fill operation followed by recessing the metal. However, metal recess processing is difficult, with high variation and problems with controlling the depth of the resultant contact placeholders.

It is with respect to these and other considerations that the present improvements have been needed. Such improvements may become critical as the desire to deploy advanced transistor structures and backside contacts becomes even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods for forming a backside contact placeholder using templated bottom-up growth, and replacement of the placeholder with a backside contact;
FIGS. 2, 3, 4, 5, 6, 7, 8, 9 10, 11, 12, 13, 14, 15, and 16 are cross-sectional side views of transistor structures evolving as the methods of FIG. 1 are practiced;
FIG. 17 is a flow diagram illustrating methods for forming a backside contact placeholder using spatially confined placeholder deposition, and replacement of the placeholder with a backside contact;
FIGS. 18, 19, 20, 21, 22, 23, 24, 25, 26, 27, 28, 29, and 30 illustrate cross-sectional side views of transistor structures evolving as the methods of FIG. 17 are practiced;
FIG. 31 is a flow diagram illustrating methods for forming a backside contact placeholder with improved process control, and replacement of the placeholder with a backside contact;
FIG. 32 illustrates exemplary systems employing transistor structures having a templated backside contact coupled to a source and/or drain structures of the transistor structures; and
FIG. 33 is a functional block diagram of an electronic computing device, all in accordance with some embodiments.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to forming backside contact placeholder or sacrificial structures that will be replaced with backside contact metals such that the placeholder or sacrificial structures have improved process control and reliability.

As discussed, gate-all-around (GAA) or nanoribbon transistors provide gate materials that surround channel regions for improved performance and backside power delivery or, more generally, backside contacts to transistor source and drain structures, can reduce resistance, and offer other advantages. In some embodiments, a trench or opening defining a location of an eventual backside contact is filled with a dielectric material such as a carbon hardmask (CHM). For example, the CHM may be any amorphous carbon based hardmask material. The dielectric material is then recessed to form a structure having the shape and location that will become the backside contact. Advantageously, dielectric material recess processing such as CHM recess processing is well known and controllable such that the height of the sacrificial structure is well controlled, in contrast to prior metal (e.g., tungsten) recess processing, which is difficult to control. The dielectric material structure is then replaced with a metal placeholder material, which will later be replaced with the eventual backside contact. For example, it is advantageous to have a metal placeholder with respect to other process operations used to form the transistor structures, metallization layers, and so on.

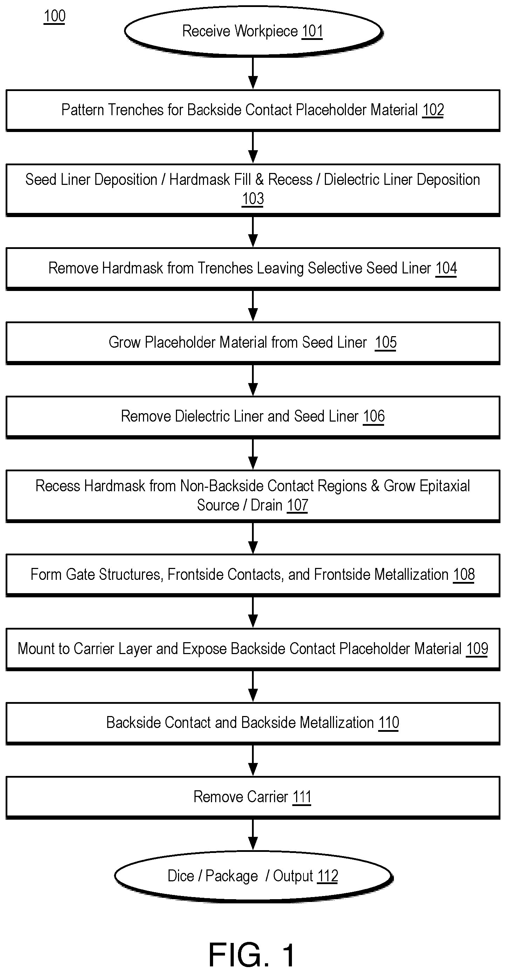

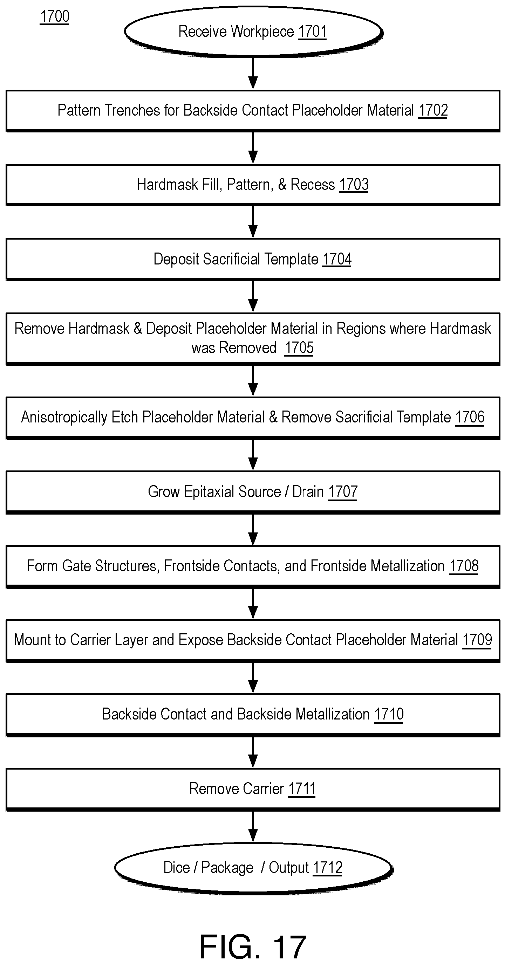

In some embodiments, the dielectric material structure is replaced with the metal placeholder using templated bottom-up growth of the backside contact metal placeholder using selective metal growth on an exposed liner material. Such techniques are discussed with respect to FIG. 1 to 16. In such embodiments, a selective tungsten growth from a titanium nitride liner material may be used. In other embodiments, the dielectric material structure is replaced with the metal placeholder using spatially confined fill of the backside contact metal placeholder using a template that exposes a void formed by removing the dielectric material structure. Such techniques are discussed with respect to FIG. 17 to 31. In such embodiments, a scaffolding material may be used to define the metal placeholder, and then is subsequently removed using a selective isotropic etch, for example.

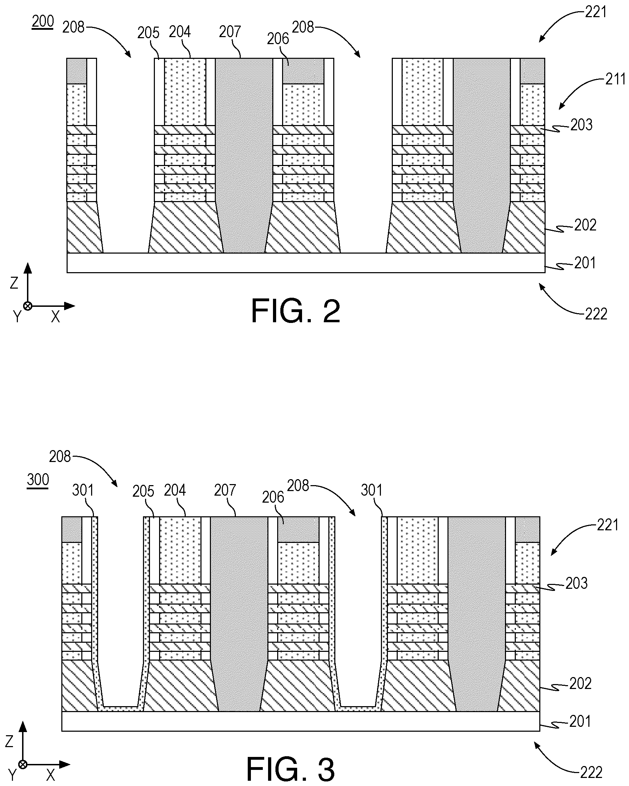

FIG. 1 is a flow diagram illustrating methods 100 for forming a backside contact placeholder using templated bottom-up growth, and replacement of the placeholder with a backside contact, arranged in accordance with at least some implementations of the present disclosure. FIGS. 2, 3, 4, 5, 6, 7, 8, 9 10, 11, 12, 13, 14, 15, and 16 are cross-sectional side views of transistor structures evolving as methods 100 are practiced, arranged in accordance with some embodiments of the disclosure. FIGS. 2, 3, 4, 5, 6, 7, 8, 9 10, 11, 12, 13, 14, 15, and 16 provide cross-sectional side views at a gate cut along a fin of the transistor structures.

Methods 100 begin at input operation 101, where a workpiece is received for processing. For example, a partially formed transistor structure formed over a substrate may be received for processing. The received substrate may include any suitable material or materials in any format. For example, the substrate may be a monocrystalline silicon wafer or the like. The partially formed transistor structure includes one or more semiconductor structures that are vertically aligned or stacked. These semiconductor structures may be silicon (Si), germanium (Ge), silicon germanium (SiGe), III-V materials (e.g., gallium arsenide (GaAs)), or other semiconductor materials such as transition metal dichalcogenide (TMD) materials. As used herein, the term semiconductor material indicates a material with a variable conductivity that may be manipulated for use as a channel material in a transistor. The semiconductor structures further include either a gate coupled to the semiconductor structures or a dummy gate in a position for later replacement by gate structures. The semiconductor structures are interleaved with and surrounded by the gates or dummy gates and the gates or dummy gates are contained by a dielectric spacer.

Processing continues at operation 102, where a trench (or hole, cavity, or opening) is patterned at any location where a backside contact will eventually be formed. For example, backside contacts may be fabricated under eventual source and/or drain structures and the trenches may be at locations of eventual source and/or drain structures that will be contacted by the backside. The trench may be formed using any suitable technique or techniques such as lithography and etch techniques. In some embodiments, both trenches for source and/or drain structures that will have backside contacts and source and/or drain structures that will have frontside contacts are formed and filled with a material such as a carbon hardmask material, and operation 102 includes patterning a resist to expose carbon hardmask material only in locations of backside contacts and selectively removing the carbon hardmask material in those trenches.

FIG. 2 illustrates a cross-sectional side view of a transistor structure 200 including trenches or deep openings 208 at locations for backside contact to source or drain structures. Transistor structure 200 includes vertically aligned stacks 211 of semiconductor structures 203 formed over substrate 201. Substrate 201 may include any suitable material or materials. For example, substrate 201 may be a substrate substantially aligned along a predetermined crystal orientation (e.g., <100>, <111>, <110>, or the like). In some embodiments, substrate 201 is a semiconductor material such as monocrystalline silicon (Si), germanium (Ge), silicon germanium (SiGe), III-V materials (e.g., gallium arsenide (GaAs)), a silicon carbide (SiC), a sapphire (Al₂O₃), or any combination thereof. In some embodiments, substrate 201 is silicon having a <111> crystal orientation.

Semiconductor structures 203 may be any materials discussed above such as silicon, germanium, silicon germanium, a III-V material, a TMD material, or others. Semiconductor structures 203 may be formed from an interleaved stack of semiconductor and sacrificial materials, which are patterned into fins, leaving a subfin 202 of, for example, silicon, as is known in the art. In some embodiments, substrate 201 is a silicon-on-insulator (SOI) substrate, with an insulator having an etch selectivity with respect to the material of subfin 202. Transistor structure 200 further include a sacrificial gate material 204 and a spacer 205, which may be fabricated as is known in the art. Sacrificial gate material 204 may be any suitable material such as polysilicon or a dielectric material. The material of spacer 205 may be a dielectric material such as one or more of silicon oxide, silicon nitride, and silicon carbide. As shown, some of sacrificial gate materials 204 may be capped with a protective material 206.

Notably, source and drain structures are to be formed from exposed regions of semiconductor structures 203. Such source and drain structures, discussed further below, are to be contacted by frontside and backside contacts, depending on device layout, circuit design, and other concerns. As shown, transistor structure 200 includes trenches or deep openings 208 at source and drain locations where backside contacts are to be formed while a fill material 207, such as a carbon hardmask material, fills those locations where backside contacts are not desired. Deep openings 208 extend from a frontside 221 in the negative z-direction through subfin 202 (and, optionally portions of substrate 201) toward a backside 222 of transistor structure 200, which is opposite frontside 221. As used herein the term frontside of a transistor structure indicates the side (or the direction of the side) being built up during front end of line (FEOL) processing of transistor structure 200, which is the processing performed on or over the received substrate 201, in accordance with the accepted use of frontside. The backside is then opposite the frontside and is the side opposite the buildup direction. As discussed below, deep openings 208 will be used to contact a source or drain structure from backside 222.

Returning to FIG. 1, processing continues at operation 103, where a seed liner is deposited in the trench or opening formed at operation 102, a hardmask fill is formed in the lined opening, the hardmask fill is recessed in those source/drain regions where backside contact is to be made, and a dielectric liner is deposited. The seed liner may be deposited using any suitable technique or techniques such as physical vapor deposition (PVD), atomic layer deposition (ALD), chemical vapor deposition (CVD), plasma enhanced chemical vapor deposition (PECVD), or the like. Notably, the seed liner is a material from which an eventual contact placeholder material will selectively grow. In some embodiments, the seed liner is titanium nitride (i.e., a layer including titanium and nitrogen). In some embodiments, the seed liner is substantially pure or pure titanium nitride. The seed liner may be deposited to any suitable thickness such as thickness in the range of 1 to 10 nm.

The remainder of the opening is then filled with a dielectric material such as a hardmask. In some embodiments, the fill material is a carbon hardmask material such as an amorphous carbon-based material. The remainder of the opening may be filled using any suitable technique or techniques such as PVD inclusive of DC sputtering techniques, CVD, ALD, or the like. In some embodiments, planarization techniques are deployed after hardmask fill to provide a substantially planar upper work surface. The dielectric material in the discussed trench or opening is then recessed. In some embodiments, a patterned resist layer exposes the trench or opening and the recess is performed using known etch techniques such as timed etch techniques to form a sacrificial or placeholder contact structure. Advantageously, the recess of a dielectric material such as a carbon hardmask material can be well controlled to provide a structure having a desired thickness and exposing a desired portion of the transistor structure (i.e., to expose the semiconductor structures).

Subsequently, a second liner such as a dielectric liner is formed within the recessed opening, on the recessed placeholder contact structure, and on the seed liner. The second liner material may be any suitable material that adheres to the seed liner and will not allow growth of the metal that selectively grows on the seed liner. In some embodiments, the second liner is silicon oxide (e.g., the second liner includes silicon and oxygen). In some embodiments, the second liner is substantially pure or pure silicon oxide. However, other materials may be used. In subsequent processing, when a portion of the seed liner is exposed, the second liner and the seed liner allow for selective growth of a metal sacrificial or placeholder contact structure.

FIG. 3 illustrates a cross-sectional side view of a transistor structure 300 similar to transistor structure 200 after formation of a liner 301. As shown, liner 301 is formed conformally within deep opening 208 using, for example, PVD, ALD, CVD, PECVD, or the like. Liner 301 may be deposited to any suitable thickness such as thickness in the range of 1 to 10 nm. In some embodiments, planarization processing is performed after deposition of liner 301 to provide a substantially planar frontside 221 working surface. However, such planarization processing may be performed after fill of deep opening 208. Notably, liner 301 may be any suitable material from which an eventual contact placeholder material will selectively grow relative to a dielectric liner. In some embodiments, liner 301 is titanium nitride (i.e., a layer including titanium and nitrogen). In some embodiments, liner 301 is substantially pure or pure titanium nitride.

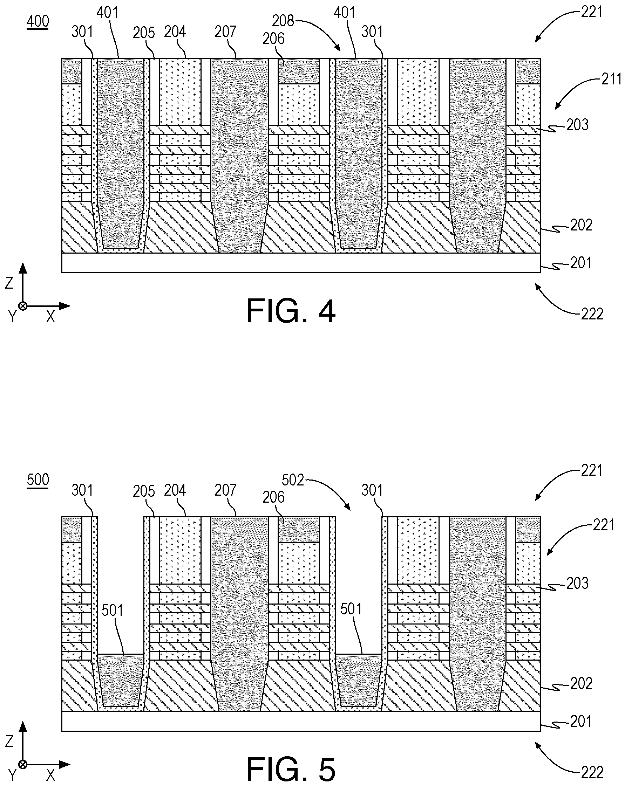

FIG. 4 illustrates a cross-sectional side view of a transistor structure 400 similar to transistor structure 300 after formation of fill material 401 on liner 301. Fill material 401 is formed to entirely fill deep opening 208 and is formed conformally within deep opening 208 using, for example, PVD, CVD, ALD, or the like. In some embodiments, fill material 401 is formed with an overburden that is removed using planarization processing to form a substantially planar frontside 221 working surface. However, such planarization processing may be performed after fill of deep opening 208. Fill material 401 may be any suitable material that may be reliably and accurately recessed within deep opening 208, and that has an etch selectivity relative to the other materials to be exposed in deep opening 208. In some embodiments, fill material 401 is a carbon hardmask material such as an amorphous carbon-based material.

FIG. 5 illustrates a cross-sectional side view of a transistor structure 500 similar to transistor structure 400 after recessing fill material 401 to form a sacrificial or placeholder contact structure 501 within recessed opening 502. As discussed, recess of fill material 401 may be well controlled to provide a frontside 221 surface that is accurately recessed to a position below a bottom one of semiconductor structures 203 but not overly recessed such that a source or drain structure may be contained laterally adjacent to semiconductor structures 203. For example, frontside 221 surface of placeholder contact structure 501 may be laterally adjacent a portion of spacer 205 and above subfin 202 (or above or laterally adjacent a bottom surface of sacrificial gate material 204). Notably, in contrast to recessing metal materials such as tungsten, fill material 401 may be accurately and reliably recessed for improved transistor structure formation.

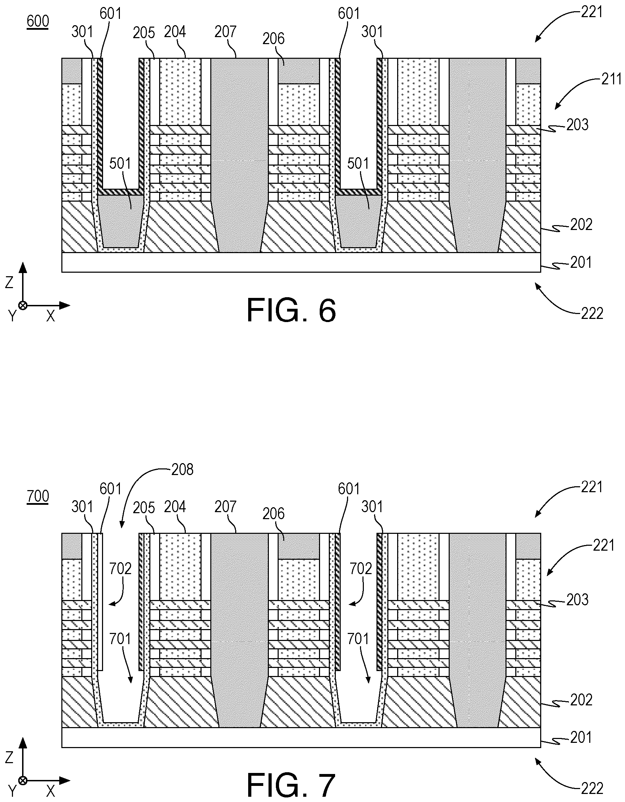

FIG. 6 illustrates a cross-sectional side view of a transistor structure 600 similar to transistor structure 500 after formation of a second liner 601, such as a dielectric liner material. As shown, liner 601 is formed conformally within deep opening 208 using, for example, PVD, ALD, CVD, PECVD, or the like. Liner 601 may be deposited to any suitable thickness such as thickness in the range of 1 to 10 nm. In some embodiments, planarization processing is performed after deposition of liner 301 to provide a substantially planar frontside 221 working surface. However, such planarization processing may be bypassed

As shown, liner 601 is formed within recessed opening 502 such that liner 601 is on frontside 221 surface of placeholder contact structure 501 and on liner 301. Although discussed with respect to a dielectric material, liner 601 may be any suitable liner material. Liner 601 may be any suitable material that adheres to liner 301 and will provide selective growth of a metal only on exposed portions of liner 301 but not on exposed portions of liner 601. In some embodiments, liner 601 is silicon oxide such that liner 601 includes silicon and oxygen. In some embodiments, liner 601 is substantially pure or pure silicon oxide. However, other materials may be used.

Returning to FIG. 1, processing continues at operation 104, where the hardmask material formed and recessed at operation 103 is removed from the opening to leave a template on the seed liner also formed at operation 103. Notably, the seed liner is exposed where the recessed hardmask material covered it while being covered by the dielectric liner where the recessed hardmask material did not cover it. Thereby, the seed liner is templated with the recessed hardmask material to subsequently form a placeholder. The hardmask material may be removed using any suitable technique or techniques such as selective etch techniques.

FIG. 7 illustrates a cross-sectional side view of a transistor structure 700 similar to transistor structure 600 after removal of placeholder contact structure 501 to provide exposed regions 701 of liner 301 within trenches or deep openings 208. Exposed regions 701 of liner 301 provide a template for the subsequent growth of a metal placeholder contact as discussed below. Remaining regions 702 of liner 601 block such metal growth. Regions 701 of liner 301 may be removed using selective etch techniques, for example.

Returning to FIG. 1, processing continues at operation 105, where a placeholder metal is grown from the regions of the seed liner exposed at operation 104 while being suppressed from growing on the remaining portions of the dielectric liner. The placeholder metal may be grown from the exposed seed liner using any suitable technique or techniques. In some embodiments, the placeholder metal is tungsten grown from a titanium nitride seed liner. Notably, tungsten selectively grown from titanium nitride while not growing from other surfaces such as silicon oxide surfaces and other dielectric materials. By growing the placeholder metal in a bottom-up manner from the bottom of the exposed opening, the need for metal recess processing is eliminated. As discussed, such metal recessing has difficulties that are thereby avoided. The placeholder metal grown at operation 105 has a convex top surface due to the discussed bottom-up growth. This is in contrast to the convex profile of metals recessed by etch processing.

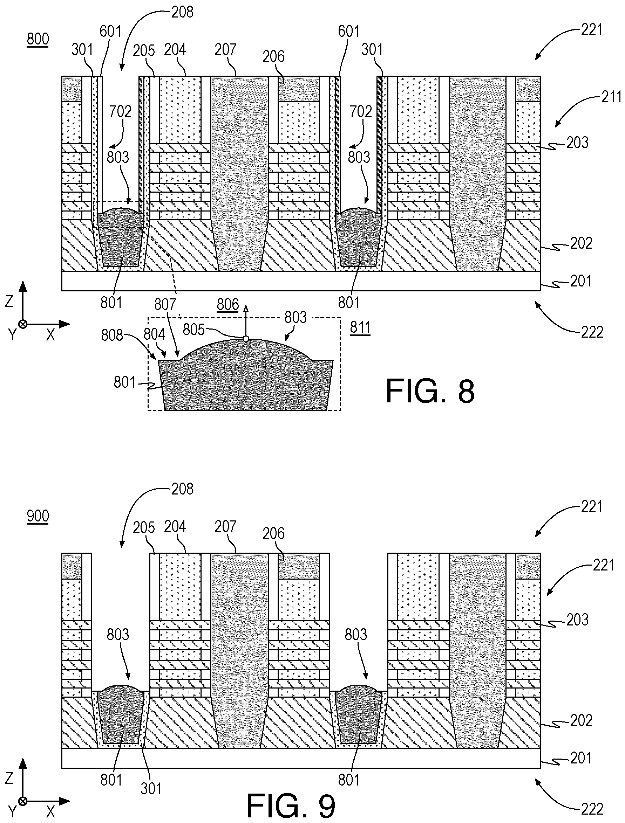

FIG. 8 illustrates a cross-sectional side view of a transistor structure 800 similar to transistor structure 700 after growth of metal placeholder contact structure 801. As discussed, metal placeholder contact structure 801 is grown from exposed regions 701 of liner 301 within trenches or deep openings 208 while not growing from regions 702 of liner 601, which block such metal growth. Thereby, metal placeholder contact structure 801 is templated to be formed at the same location and of substantially the same size as placeholder contact structure 501 (refer to FIG. 5). However, metal placeholder contact structure 801 has a convex surface 803 (i.e., a convex top surface) facing frontside 221, which is shown in greater detail in expanded view 811. Convex surface 803 is characteristic of the growth of metal placeholder contact structure 801 from exposed regions 701 of liner 301.

Convex surface 803 may have any suitable radius of curvature such as a radius of curvature in the range of 5 to 50 nm. In some embodiments, the radius of curvature is not less than 5 nm. In some embodiments, the radius of curvature is not less than 20 nm. In some embodiments, the radius of curvature is not less than 40 nm. Other dimensions may be deployed. Furthermore, although illustrated with a substantially symmetric curved surface, in some embodiments, convex surface 803 may have a pitched surface with flat or substantially flat surface portions.

In some embodiments, convex surface 803 has an apex 805, which is a top point of convex surface 803 and metal placeholder contact structure 801. In some embodiments, apex 805 is substantially at a lateral midpoint of convex surface 803 and metal placeholder contact structure 801. In some embodiments, a vector 806 normal to convex surface 803 at the apex 805 is substantially orthogonal to the x-y plane. As shown, the x-y plane is substantially parallel to the working surface of frontside 221 as well as frontside and backside surfaces of substrate 201. In some embodiments, metal placeholder contact structure 801 further includes a substantially flat surface 804 adjoining convex surface 803. Flat surface 804 may be formed in a region blocked and templated by a portion of liner 601, for example. In some embodiments, substantially flat surface 804 extends from convex surface 803 at an inflection 807 to a lateral edge 808 of metal placeholder contact structure 801. For example, lateral edge 808 is the outermost edge or position of metal placeholder contact structure 801 in the lateral x-y plane.

Returning to FIG. 1, processing continues at operation 106, where the dielectric liner and then the seed liner are removed using any suitable technique or techniques. In some embodiments, the dielectric liner and the seed liner are removed using etch techniques such as successive wet etch operations.

FIG. 9 illustrates a cross-sectional side view of a transistor structure 900 similar to transistor structure 800 after removal of the remaining portions of liner 601 and liner 301. For example, liner 601 may be removed using a selective silicon oxide etch and liner 301 may then be removed using a selective titanium nitride etch. However, other materials and pertinent etches may be used.

Returning to FIG. 1, processing continues at operation 107, where the dielectric material (i.e., hardmask fill) is recessed in those source/drain regions where backside contact is not to be made, and source and drain materials are grown from the exposed semiconductor materials. The dielectric material in the discussed trench or opening may be recessed using any suitable technique or techniques such as those discussed with respect to operation 105. In some embodiments, a patterned resist layer exposes the trench or opening and the recess is performed using known etch techniques such as timed etch techniques. As discussed, the recess of a dielectric material such as a carbon hardmask material can be well controlled.

Source and drain semiconductor materials are then deposited (e.g., epitaxially grown). For example, the source and drain semiconductor materials suitable for the conductivity type of the GAA transistor being formed (n-type or p-type) may be deposited while other regions are masked and subsequently, source and drain semiconductor materials suitable for another conductivity type of the GAA transistor being formed (the other of n-type or p-type) using masking techniques. Such source and drain structures may be characterized as impurity doped regions. Epitaxial source and drain semiconductor materials (i.e., impurity doped regions) are selectively formed on the exposed semiconductor materials (e.g., channel silicon). Such epitaxial growth techniques may be performed using any suitable technique or techniques. In some embodiments, vapor phase epitaxy is deployed. In some embodiments, the epitaxial growth includes molecular beam epitaxy techniques. Such epitaxial growth is selective to exposed crystal surfaces of the semiconductor material(s) and grows substantially crystalline source and drain materials that are epitaxial to (e.g., share a crystal orientation with) the semiconductor material(s).

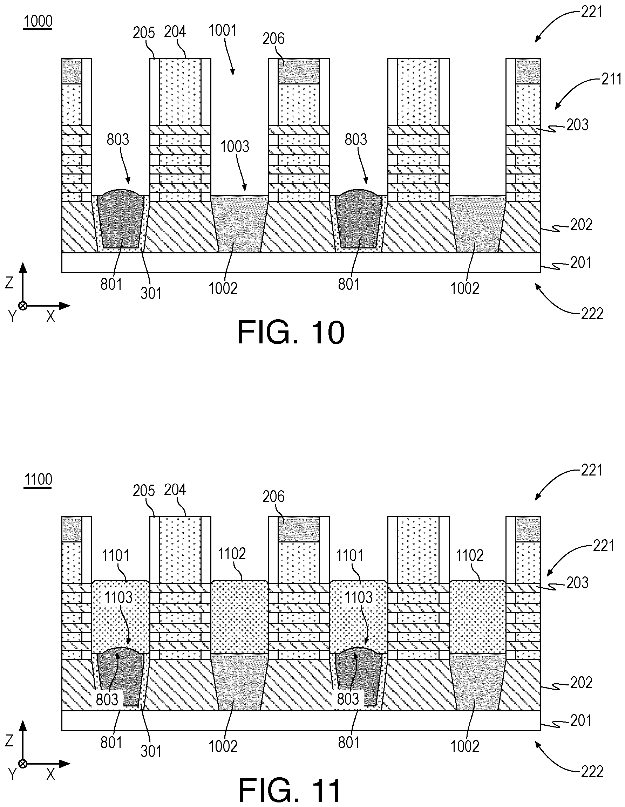

FIG. 10 illustrates a cross-sectional side view of a transistor structure 1000 similar to transistor structure 900 after recessing fill material 207 to form a recessed dielectric structure 1002 within recessed opening 1001. As shown, a frontside 221 surface of recessed dielectric structure 1002 is substantially planar or may have a concave shape in contrast to convex surface 803 of metal placeholder contact structure 801. Recessed dielectric structure 1002 has a surface 1003 that is accurately recessed to a position below a bottom one of semiconductor structures 203 but not overly recessed such that a source or drain structure may be contained laterally adjacent to semiconductor structures 203.

FIG. 11 illustrates a cross-sectional side view of a transistor structure 1100 similar to transistor structure 1100 after formation of source structures 1101 and drain structures 1102. Source structures 1101 and drain structures 1102 may be formed using any suitable technique or techniques such as vapor phase epitaxy techniques, molecular beam epitaxy techniques, or other epitaxial growth techniques. As shown, source structures 1101 and drain structures 1102 grow epitaxially from exposed semiconductor structures 203. Source structures 1101 and drain structures 1102 may include faceting and growth structures and characteristics as known in the art. Source structures 1101 and drain structures 1102 may include any suitable material or materials for the conductivity type of the transistor structure being formed. In some embodiments, for n-type metal oxide semiconductor (NMOS) transistors, source structure 1101 and drain structure 1102 are epitaxial silicon doped with n-type dopants inclusive of phosphorous, arsenic, antimony, or others. For example, NMOS source and drain semiconductor materials may include silicon and one or more of phosphorous, arsenic, and antimony. In some embodiments, for p-type metal oxide semiconductor (PMOS) GAA transistors, source structure 1101 and drain structure 1102 are epitaxial silicon germanium doped with p-type dopants inclusive of boron, aluminum, gallium, indium, or others. For example, PMOS source and drain semiconductor materials may include silicon and germanium, and one or more of boron, aluminum, gallium, and indium. Other materials may be used.

As shown, source structure 1101 and drain structure 1102 each have a concave surface 1103 corresponding to the convex surfaces 803 of metal placeholder contact structures 801. For example, source structure 1101 and drain structure 1102 materials are grown to have a mirror shape with respect to convex surfaces 803 and substantially flat surfaces 804.

Returning to FIG. 1, processing continues at operation 108, where gate structures are formed, frontside contacts are made, and frontside metallization layers are fabricated. Such processing may be performed using any suitable technique or techniques. In some embodiments, the sacrificial structure adjacent the semiconductor structures (e.g., channel semiconductor materials) and/or dummy gate materials are replaced with gate structures. For example, the sacrificial layers may be selectively etched, and the requisite structures may be formed via deposition and optional patterning techniques. Furthermore, source or drain structures and the gate structures may be contacted by metal contacts using any suitable technique or techniques such as patterning and metal deposition processing known in the art. Finally, frontside metallization layers may be formed over (and selectively coupled to) the frontside contacts using any suitable technique or techniques such as dual damascene techniques, single damascene techniques, subtractive metallization patterning techniques, or the like. Although discussed with respect to a particular sequence of the formation of such structures, they may be fabricated in any suitable sequence.

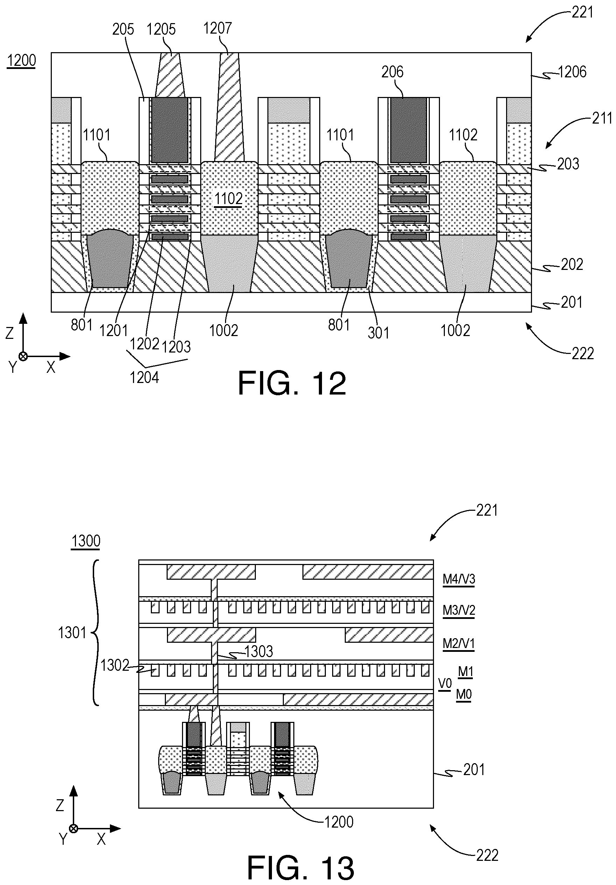

FIG. 12 illustrates a cross-sectional side view of a transistor structure 1200 similar to transistor structure 1100 after formation of gate structures 1204, drain contact 1207, gate contact 1205, and dielectric material 1206. As shown, gate structures 1204 include gate dielectric 1203 separating gate electrodes 1202 from channel regions 1201 of semiconductor structures 203. Such gate electrodes 1202 and gate dielectric 1203 may be formed using any suitable technique or techniques such as replacement gate techniques. Furthermore, frontside gate contacts 1205 and drain contact 1207 may be formed using any suitable technique or techniques such as patterning, etch, and metal deposition techniques. Although illustrated with respect to drain contact 1207 contacting drain structure 1102, frontside contact may be made to source structure 1101 in addition or in the alternative.

Such components may include any suitable materials. Gate dielectric 1203 may be silicon oxide, aluminum oxide, or a high-k dielectric, such as hafnium oxide. For example, gate dielectric 1203 may include elements such as hafnium, silicon, oxygen, titanium, tantalum, lanthanum, aluminum, zirconium, barium, strontium, yttrium, lead, scandium, niobium, or zinc. Gate electrodes 1202 may include any suitable work function metal for gate control of GAA transistors of transistor structure 1200 such as tantalum, titanium, aluminum, ruthenium, or alloys of such materials. Drain contact 1207 may include any suitable conductive contact materials such as tungsten, copper, cobalt, aluminum, titanium, or the like. Dielectric material 1206 may be any suitable insulative material such as silicon oxide.

FIG. 13 illustrates a cross-sectional side view of a transistor structure 1300 similar to transistor structure 1200 after formation of frontside metallization layers 1301 (or frontside interconnect layers). Frontside metallization layers 1301 may be formed using any suitable technique or techniques such as dual damascene techniques, single damascene techniques, subtractive metallization patterning techniques, or the like. For example, interconnectivity, signal routing, power-delivery, and the like may be provided by frontside metallization layers 1301. As used herein, the term metallization layer indicates metal interconnections or wires that provide electrical routing. Adjacent metallization layers, such as metallization interconnects 1302, are interconnected by vias, such as vias 1303, that may be characterized as part of the metallization layers or between the metallization layers. As shown, in some embodiments, frontside metallization layers 1301 are formed over and immediately adjacent transistor structure 1200. In the illustrated example, frontside metallization layers 1301 include M0, V0, M1, M2/V1, M3/V2, and M4/V3. However, frontside metallization layers 1301 may include any number of metallization layers such as six, eight, or more metallization layers.

Returning to FIG. 1, processing continues at operation 109, where the partially fabricated workpiece is mounted, by its frontside, to a carrier such as a carrier wafer, and the backside contact sacrificial material is exposed through the backside of the substrate of the workpiece. The workpiece may be mounted to the carrier using any suitable technique or techniques such as application of an adhesive film between the workpiece and carrier. The backside contact sacrificial material is the exposed using any suitable technique or techniques such as backside substrate removal processing including backside grind, backside etch or the like to thin the substrate wafer.

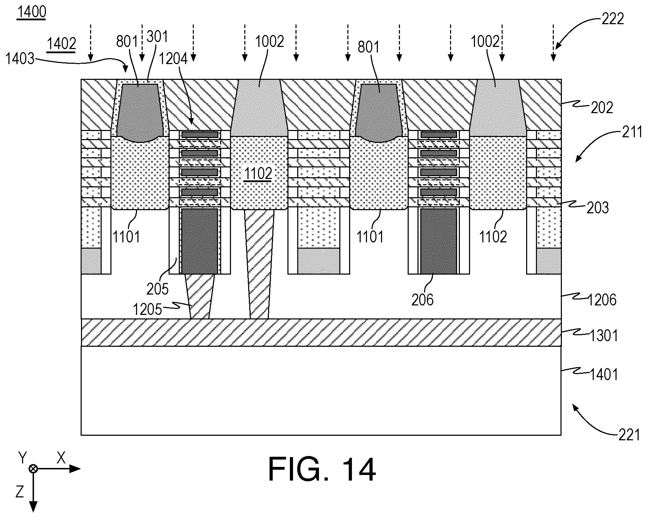

FIG. 14 illustrates a cross-sectional side view of a transistor structure 1400 similar to transistor structure 1300 after attachment to carrier 1401, and backside substrate removal processing 1402 to expose a backside surface 1403 of metal placeholder contact structures 801. In FIG. 14, frontside metallization layers 1301 are illustrated condensed into a single component for the sake of clarity of presentation. Furthermore, the view of FIG. 14 is inverted with respect to that of FIG. 13. For example, substrate removal processing 1402 may include backside grind (e.g., backside planarization) or backside etch processing that thins substrate 201 and/or subfins 202 in a planar fashion to expose instances of metal placeholder contact structures 801 for backside contact processing.

Returning to FIG. 1, processing continues at operation 110, where a contact metal is formed by replacement of the backside contact metal placeholder material formed at operation 105, and after backside metallization layers are fabricated. Such processing may be performed using any suitable technique or techniques. In some embodiments, the backside contact metal placeholder material is removed using selective etch processing and replaced with backside contact metal using deposition and planarization techniques. Furthermore, backside metallization layers may be formed over (and selectively coupled to) the backside contacts using any suitable technique or techniques such as dual damascene techniques, single damascene techniques, subtractive metallization patterning techniques, or the like.

Processing continues at operation 111, where the carrier is removed using any suitable technique or techniques such as delamination, UV curing, or the like, and at operation 112, where continued processing is performed as is known in the art. Such processing may include dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

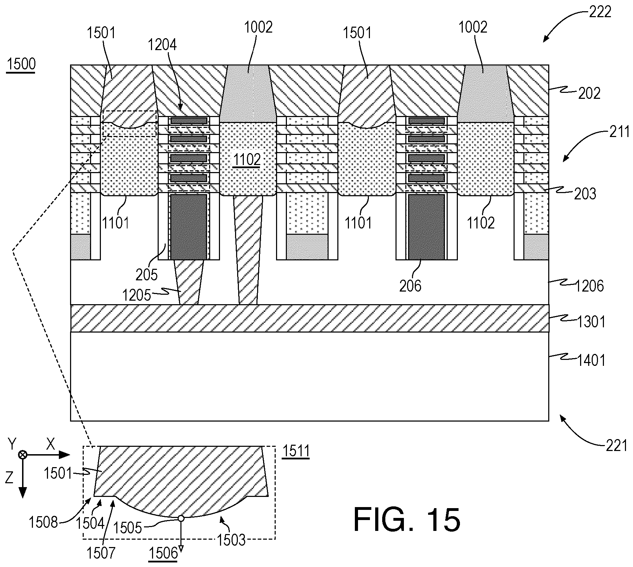

FIG. 15 illustrates a cross-sectional side view of a transistor structure 1500 similar to transistor structure 1400 after removal of any remaining portions of liner 301 and removal metal placeholder contact structures 801, and formation of backside contacts 1501 (e.g., backside contact metal). For example, liner 301 and metal placeholder contact structure 801may be removed using selective etch techniques and the resultant contact hole may be filled by metal backside contact 1501 using deposition and planarization techniques. Backside contact 1501 may include any suitable materials for contacting source structure 1101 (and/or drain structure 1102). In addition to the bulk material of backside contact 1501, backside contact 1501 may include a silicide layer or other chemical compound layer (not shown) formed on backside surfaces of source structures 1101 and/or drain structures 1102 prior to formation of the bulk material of backside contact 1501. Such materials may reduce the contact resistance to source structures 1101 and/or drain structures 1102. The silicide layer or other chemical compound layer and the bulk material of backside contact 1501 may be formed using any suitable technique or techniques. For example, the silicide layer or other chemical compound layer may be formed by application of a thin layer (e.g., titanium, nickel, sodium, magnesium, platinum, tungsten, molybdenum, etc.) followed by an anneal process. Subsequently, the fill metal of backside contact 1501 may be deposited and planarized. In some embodiments, a layer of titanium nitride (e.g., a layer including titanium and nitrogen is first formed). The fill metal of backside contact 1501 may be any suitable contact metal such as molybdenum, tungsten, cobalt, a combination thereof, or other metal(s).

As shown, backside contact 1501 has a convex surface 1503 (i.e., a convex top surface) in accordance with convex surface 803 (refer to FIG. 8). Convex surface 1503 faces frontside 221, and is shown in greater detail in expanded view 1511. Convex surface 1503 is characteristic of the growth of metal placeholder contact structure 801 from exposed regions 701 of liner 301 (refer to FIG. 8). Convex surface 1503 may have any suitable radius of curvature such as a radius of curvature in the range of 5 to 50 nm. In some embodiments, the radius of curvature is not less than 5 nm. In some embodiments, the radius of curvature is not less than 20 nm. In some embodiments, the radius of curvature is not less than 40 nm. Other dimensions may be deployed. Furthermore, although illustrated with a substantially symmetric curved surface, in some embodiments, convex surface 1503 may have a pitched surface with flat or substantially flat surface portions.

In some embodiments, convex surface 1503 has an apex 1505, which is a top point of convex surface 1503 and backside contact 1501. In some embodiments, apex 1505 is substantially at a lateral midpoint of convex surface 1503 and backside contact 1501. In some embodiments, a vector 1506 normal to convex surface 1503 at the apex 1505 is substantially orthogonal to the x-y plane. As shown, the x-y plane is substantially parallel to the working surface of frontside 221 as well as frontside and backside surfaces of substrate 201. In some embodiments, backside contact 1501 further includes a substantially flat surface 1504 adjoining convex surface 1503. In some embodiments, substantially flat surface 1504 extends from convex surface 1503 at an inflection 1507 to a lateral edge 1508 of backside contact 1501. For example, lateral edge 1508 is the outermost edge or position of backside contact 1501 in the lateral x-y plane. In some embodiments, convex surface 1503 includes the discussed silicide layer or thin layer of material deposited prior to bulk deposit. In some embodiments, convex surface 1503 (e.g., a depth of 1 to 3 nm at the interface and extending into backside contact 1501) includes titanium, nickel, sodium, magnesium, platinum, tungsten, or molybdenum, etc.) In some embodiments, convex surface 1503 (e.g., a depth of 1 to 3 nm at the interface and extending into backside contact 1501) includes titanium and nitrogen.

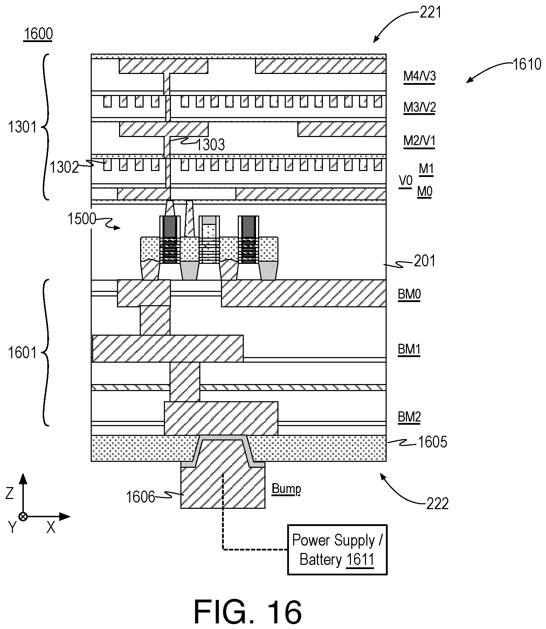

FIG. 16 illustrates a cross-sectional side view of a transistor structure 1600 similar to transistor structure 1500 after formation of backside metallization layers 1601 (or backside interconnect layers). The view of FIG. 16 is inverted with respect to that of FIG. 15. Backside metallization layers 1601 may be formed using any suitable technique or techniques such as dual damascene techniques, single damascene techniques, subtractive metallization patterning techniques, or the like. After such processing, carrier 1401 is removed. For example, interconnectivity, signal routing, power-delivery, and routing to outside devices (not shown) may be provided by backside metallization layers 1601. In the illustrated example, package level interconnects 1606 are provided on or over backside 222 as bumps over a passivation layer 1605. However, package level interconnects 1606 may be provided using any suitable interconnect structures such as bond pads, solder bumps, etc. As shown, in some embodiments, backside metallization layers 1601 are formed over and immediately adjacent transistor structure 1500. In the illustrated example, backside metallization layers 1601 include BM0, BM1, and BM2 with intervening via layers. However, backside metallization layers 1601 may include any number of metallization layers such as three, four, or more metallization layers. In some embodiments, transistor structure 1600 is deployed in a monolithic integrated circuit (IC) die 1610 including a GAA transistor structure (e.g., a GAA-FET), the transistor structure including any of the discussed components and characteristics. As shown, a power supply 1611 may be coupled to IC die 1610, such that power supply 1611 may include a battery, voltage converter, power supply circuitry, or the like.

With reference to FIGS. 15 and 16, transistor structure 1600 includes one or more frontside metallization layers 1301 and one or more backside metallization layers 1601. Transistor structure 1500 (or any other transistor structure discussed herein) includes semiconductor structures 203 between and coupling first and second impurity doped regions (i.e., source and drain structures 1101, 1102), and gate electrodes 1202 adjacent semiconductor structures 203 such that transistor structure 1500 is between frontside metallization layers 1301 and backside metallization layers 1601. Transistor structure 1600 further includes backside contact 1501 coupled to a first impurity doped region (one of source and drain structures 1101, 1102) and backside metallization layers 1601 such that backside contact 1501 has convex surface 1503 on the first impurity doped region.

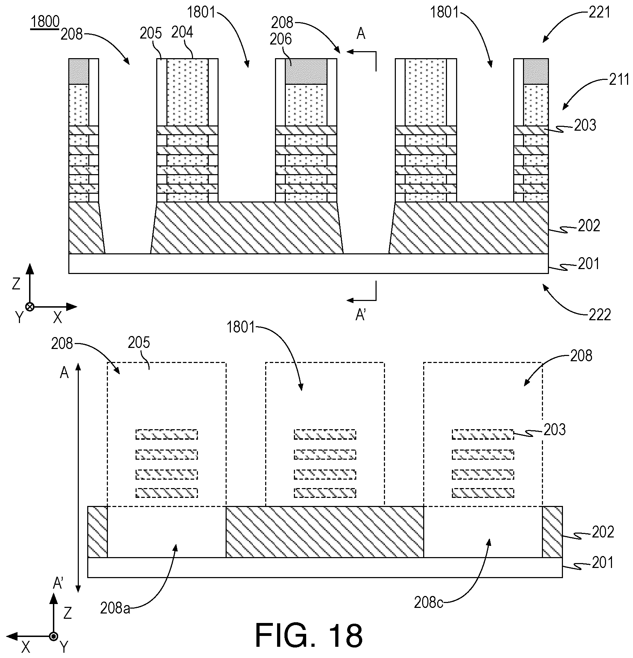

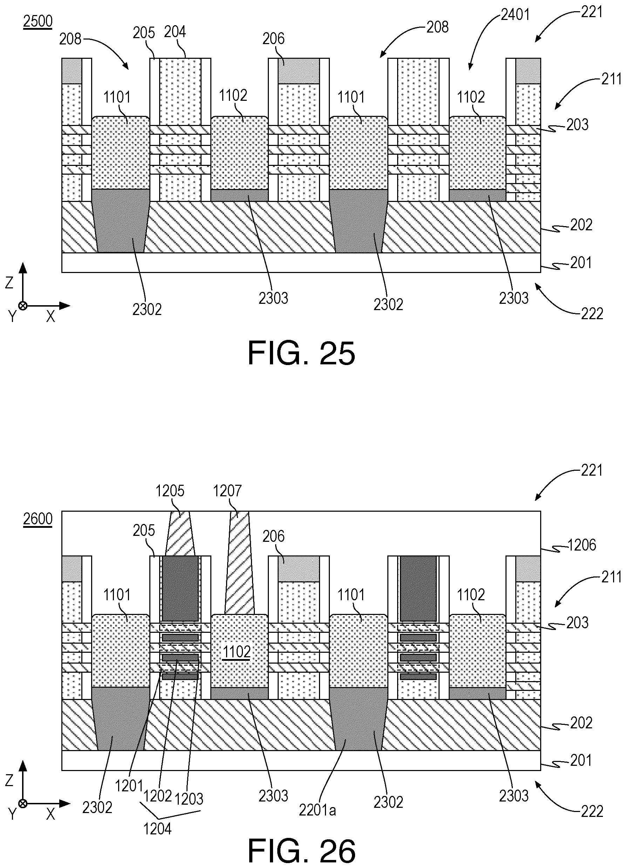

FIG. 17 is a flow diagram illustrating methods 1700 for forming a backside contact placeholder using spatially confined placeholder deposition, and replacement of the placeholder with a backside contact, arranged in accordance with at least some implementations of the present disclosure. FIGS. 18, 19, 20, 21, 22, 23, 24, 25, 26, 27, 28, 29, and 30 illustrate cross-sectional side views of transistor structures evolving as methods 1700 are practiced, arranged in accordance with some embodiments of the disclosure. FIGS. 18, 19, 20, 21, 22, 23, and 24 provide cross-sectional side views at a gate cut along a fin of the transistor structures and cross-sectional side views at a fin cut on a source or drain of the transistor structures. FIGS. 25, 26, 27, 28, 29, and 30 provide cross-sectional side views only at the gate cut along the fin of the transistor structures.

Methods 1700 begin at input operation 1701, where a workpiece is received for processing. For example, a partially formed transistor structure formed over a substrate may be received for processing. The received substrate and may semiconductor structures include any suitable material(s) or characteristic(s) discussed herein above. The semiconductor structures further include either a gate coupled to the semiconductor structures or a dummy gate in a position for later replacement by gate structures. The semiconductor structures are interleaved with and surrounded by the gates or dummy gates and the gates or dummy gates are contained by a dielectric spacer.

Processing continues at operation 1702, where deep trenches (or holes, cavities, or openings) are patterned at locations where a backside contact will eventually be formed such that the deep backside contact trenches extend below the semiconductor structures while those locations where backside contacts are not to be made do not extend below the semiconductor structures. For example, backside contacts may be fabricated under eventual source and/or drain structures and the deep trenches may be at locations of eventual source and/or drain structures that will be contacted by the backside. Trenches that will not be the sites of backside contacts do not extend below the semiconductor structures but expose the semiconductor structures for eventual source/drain growth in the trenches. The deep trenches may be formed using any suitable technique or techniques such as lithography and etch techniques. Such deep trenches may be located at source sites, drain sites, or at both.

FIG. 18 illustrates cross-sectional side views of a transistor structure 1800 including deep trenches or openings 208 at locations for backside contact to source or drain structures and shallow or standard openings 1801 at locations where backside contact will not be made. In FIGS. 18 to 24, the top cross-sectional side views are of a gate cut along a fin of the transistor structures. The bottom cross-sectional side views are of a fin cut on a source or drain of the transistor structures. For example, the bottom cross-sectional side views illustrate two backside contact deep openings 208 with one on either side of a standard opening 1801. In this view, the dashed lines show structures that are in the background of the view. Notably, the bottom view is taken at A-A' in the top view. Furthermore, portions 208a, 208c of deep openings 208 (below eventual source/drain materials) are locations for backside contact placeholders and eventual backside contacts, while standard openings 1801 is not to be used for backside contact. Instead, in standard openings 1801, the eventual source/drain materials will be formed on or over subfin 202 (or substrate 201) without backside contact placeholders.

As discussed above with respect to transistor structure 200, transistor structure 1800 includes vertically aligned stacks 211 of semiconductor structures 203 formed over substrate 201. In the FIGS., like components may have any characteristics discussed elsewhere herein. Transistor structure 1800 further include sacrificial gate material 204 and spacer 205, and some of sacrificial gate materials 204 may be capped with a protective material 206. Source and drain structures are to be formed from exposed regions of semiconductor structures 203. Such source and drain structures, discussed further below, are to be contacted by frontside and backside contacts, depending on device layout, circuit design, and other concerns. Transistor structure 1800 includes deep openings 208 at source and drain locations where backside contacts are to be formed and standard openings 1801 at source and drain locations where backside contacts are not desired. Deep openings 208 extend from frontside 221 in the negative z-direction through subfin 202 (and, optionally portions of substrate 201) toward backside 222 of transistor structure 1800.

Returning to FIG. 17, processing continues at operation 1703, where a hardmask fill is formed, patterned and recessed. Such processing provides the hardmask fill in regions and locations where backside contact placeholder material is desired. As discussed above, recessing hardmask fill is more controllable, reliable, and repeatable relative to recessing the metal material of the backside contact placeholder. The fill material (e.g., hardmask fill or dielectric material) may be formed in the openings using any suitable technique or techniques such as PVD inclusive of DC sputtering techniques, CVD, ALD, or the like. In some embodiments, the fill material is a carbon hardmask material such as an amorphous carbon-based material. The fill material is then patterned and recessed to provide the carbon hardmask fill structures at locations where backside contact is to be made, and to provide the carbon hardmask fill structures such that those locations are accessible. That is, the carbon hardmask fill backside contact structures must not be isolated. If they were, they could not be etched out and replaced by metal backside contact placeholder material. Such patterning and recessing may be performed using any suitable technique or techniques such as lithography and timed etch techniques. In some embodiments, after bulk hardmask fill, planarization is performed to provide a substantially flat working surface prior to the discussed patterning and recess operations.

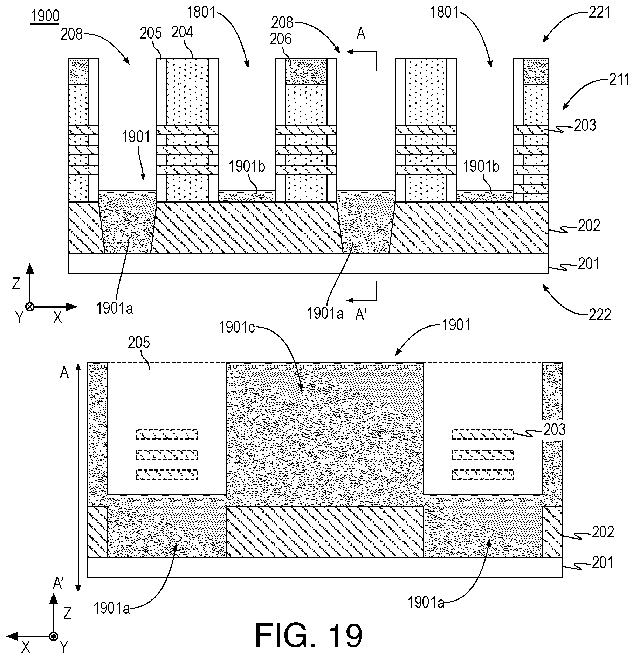

FIG. 19 illustrates a cross-sectional side view of a transistor structure 1900 similar to transistor structure 1800 after formation of patterned hardmask 1901. Patterned hardmask 1901 may be any suitable material having etch selectivity such as a carbon hardmask material. However, other dielectrics may be used. As shown, patterned hardmask 1901 includes sections or regions 1901a under eventual locations of source/drain structures where backside contact is to be made. Such regions 1901a of patterned hardmask 1901 may be formed by recessing patterned hardmask 1901 in deep openings 208, for example, while sections or regions 1901c are covered by a photoresist mask.

Furthermore, patterned hardmask 1901 includes sections or regions 1901b that are at the bottoms of standard openings 1801. For example, regions 1901b of patterned hardmask 1901 have top surfaces that are substantially coplanar with regions 1901a of patterned hardmask 1901. Such regions 1901b of patterned hardmask 1901 may be formed by recessing patterned hardmask 1901 in standard openings 1801 while sections or regions 1901c are covered by a photoresist mask. Notably, regions 1901b provide necessary access to some or all of regions 1901a. As discussed above, if regions 1901a of patterned hardmask 1901 were fully isolated, they could not be etched out and replaced by metal placeholder material. As shown in FIG. 19, in the trench or standard opening 1801, only some of the hardmask fill is recessed. The material remains in regions where placeholder contact material is not desired while regions 1901b provide the discussed necessary access to regions 1901a of patterned hardmask 1901.

Returning to FIG. 17, processing continues at operation 1704, where a sacrificial template is deposed over the hardmask fill material pattered and operation 1703. The sacrificial template may be characterized as a scaffold or scaffolding as the hardmask fill material will be removed. The sacrificial template may be formed using any suitable technique or techniques such as material fill deposition performed using PVD, CVD, ALD, or the like, followed by planarization processing. The sacrificial template may be suitable material having an etch selectivity with respect to the patterned hardmask material and other materials exposed during etch processing. In some embodiments, the sacrificial template is titanium nitride (e.g., a material including titanium and nitrogen). However, other material systems may be used.

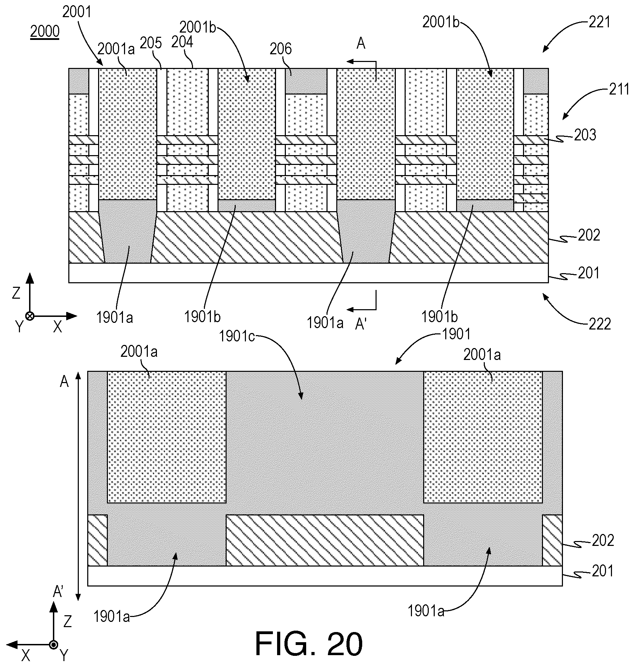

FIG. 20 illustrates a cross-sectional side view of a transistor structure 2000 similar to transistor structure 1900 after formation of sacrificial template 2001. Sacrificial template 2001 may be formed by bulk deposition followed by planarization, for example. As shown, sacrificial template 2001 fills those regions around patterned hardmask 1901 that were patterned and recessed. For example, sacrificial template 2001 provides a material at sections or regions 2001a above locations of regions 1901a of patterned hardmask 1901 where backside contact will eventually made. In some embodiments, sacrificial template 2001 is provided as a fill at locations where source and drain structures that will have backside contacts are located. Similarly, sacrificial template 2001 provides a material at sections or regions 2001b above locations of regions 1901b of patterned hardmask 1901 where backside contact will not be made but where source and drain structures will be formed. In this way, sacrificial template 2001 templates, in the reverse thereof, patterned hardmask 1901 such that patterned hardmask 1901 may be replaced by a backside contact placeholder metal. For example, sacrificial template 2001 is deposited to spatially confine a subsequent fill metal that provides the backside contact placeholder.

Returning to FIG. 17, processing continues at operation 1705, where the patterned hardmask material is selectively removed and replaced by deposition of a backside contact placeholder metal. The patterned hardmask material may be removed using any suitable technique or techniques such as selective etch techniques. In some embodiments, the patterned hardmask material is removed using an O2 ash process. The selective removal of patterned hardmask material leaves the sacrificial template formed at operation 1704.

Operation 1705 continues with deposition of the backside contact metal in regions where the patterned hardmask material was removed. The backside contact metal may be deposited using any suitable technique or techniques such as metal fill techniques inclusive of PVD, CVD, PECVD, ALD, or the like. In some embodiments, a liner material is first conformally deposited, and a bulk fill material is then deposited on the liner material. In some embodiments, the liner material is titanium nitride (e.g., a liner or layer including titanium and nitrogen) and the fill is tungsten such as substantially pure or pure tungsten.

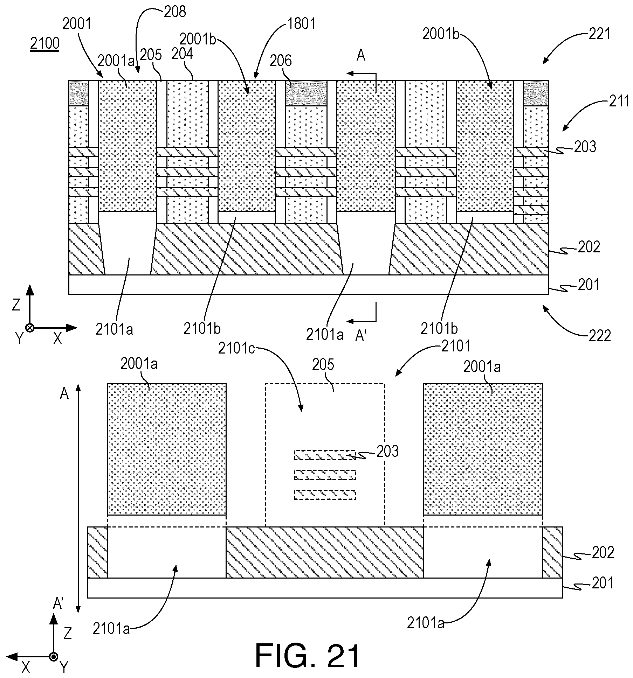

FIG. 21 illustrates a cross-sectional side view of a transistor structure 2100 similar to transistor structure 2000 after removal of patterned hardmask 1901 using, for example, selective etch techniques such as an O2 ash. As shown, removal of patterned hardmask 1901 leaves regions 2001a of sacrificial template 2001, which may be characterized as plugs, over voids 2101a, where placeholder metal for backside contacts is desired. Similarly, removal of patterned hardmask 1901 leaves regions 2001b of sacrificial template 2001 (e.g., plugs) over voids 2101b, where placeholder metal may access voids 2101a. For example, without voids 2101b and voids 2101c, which are in both regions where backside contacts are not to be made, voids 2101a would not be accessible.

Furthermore, sacrificial template 2001 (e.g., a scaffolding or scaffolding material) provides an inverse of the desired trench recesses in deep openings 208 and standard openings 1801. Notably, the depth of voids 2101b (or openings) are previously targeted using hardmask recess such that subsequent metal fill can fully fill voids 2101a (backside contact trenches) before pinching off. As will be appreciated, the eventual metal fill in voids 2101b remains after processing as necessary to deploy the targeted hardmask recess to form fill voids 2101a for backside contact trenches.

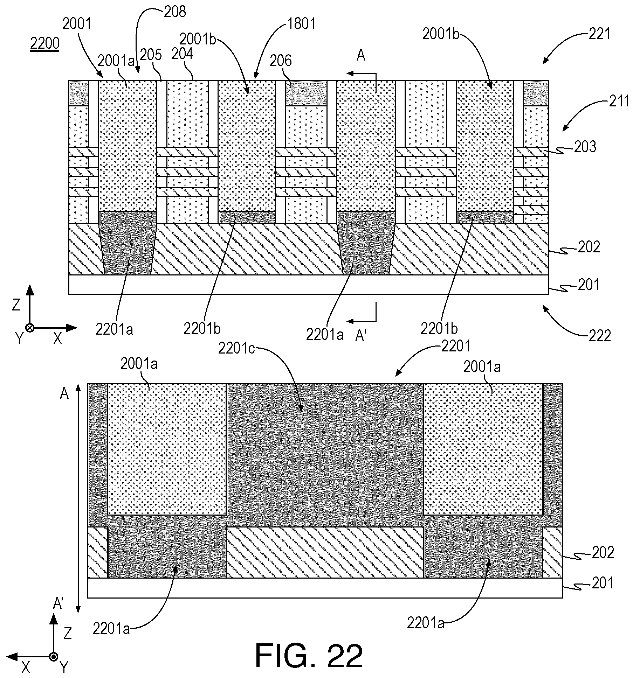

FIG. 22 illustrates a cross-sectional side view of a transistor structure 2200 similar to transistor structure 2100 after formation of metal placeholder contact materials 2201. Metal placeholder contact materials 2201 may be any suitable material. In some embodiments, metal placeholder contact materials 2201 is tungsten such as substantially pure or pure tungsten. In some embodiments, metal placeholder contact materials 2201 include a liner material such as titanium nitride (e.g., a liner including titanium and nitrogen) and a tungsten fill such as a fill of substantially pure or pure tungsten.

Metal placeholder contact materials 2201 includes sections or regions 2201a under eventual locations of source/drain structures where backside contact is to be made. Such regions 2201a of metal placeholder contact materials 2201 were templated by recessing patterned hardmask 1901 in deep openings 208, as discussed above. Furthermore, metal placeholder contact materials 2201 includes sections or regions 2201b that are at the bottoms of standard openings 1801. For example, regions 2201b of metal placeholder contact materials 2201 have top surfaces that are substantially coplanar with regions 2201a of metal placeholder contact materials 2201. Furthermore, regions 2201c of metal placeholder contact materials 2201 are formed in prior regions 1901c of patterned hardmask 1901. As discussed, regions 2201b, 2201c provide necessary access to some or all of regions 2201a during metal fill. Regions 2201a and regions 2201b are under regions 2001a and regions 2001b, respectively, of sacrificial template 2001, which will be removed and provide access for formation of source and drain structures.

Returning to FIG. 17, processing continues at operation 1706, where the metal contact placeholder material is anisotropically etched to remove it from regions that are not under eventual source and drain structure locations. Such eventual source and drain structure locations are masked by the sacrificial template formed at operation 1704. Notably, the directional anisotropic etch of the metal contact placeholder material does not need to be carefully controlled as the recessed metal contact placeholder material is masked by the sacrificial template. Operation 1706 continues with the subsequent removal of the sacrificial template. The sacrificial template may be removed using any suitable technique or techniques such as selective wet etch techniques.

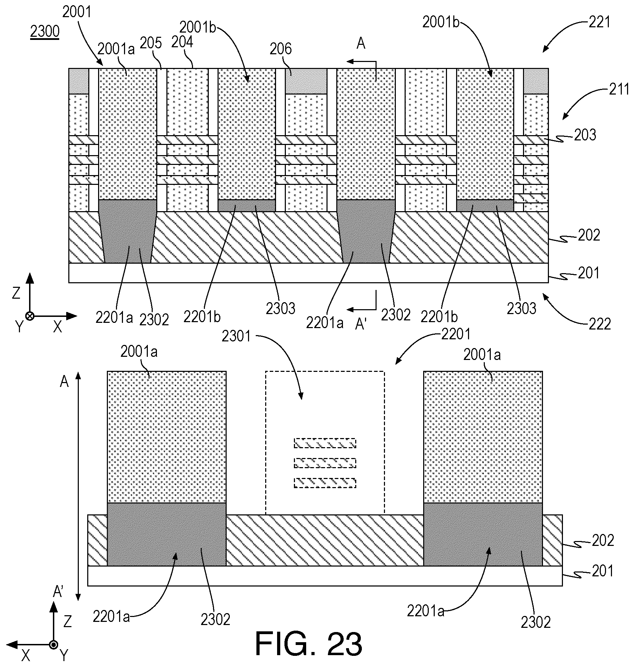

FIG. 23 illustrates a cross-sectional side view of a transistor structure 2300 similar to transistor structure 2200 after directional anisotropic etch of exposed regions 2201c of metal placeholder contact materials 2201. As shown, regions 2201a and regions 2201b of metal placeholder contact materials 2201 are protected from the directional anisotropic etch by regions 2001a and regions 2001b, respectively, of sacrificial template 2001. Thereby, metal placeholder contact structures 2302 and metal placeholder structures 2303 are formed while exposed regions 2201c of metal placeholder contact materials 2201 are removed to form a corresponding void 2301. Metal placeholder contact structures 2302 in analogy to metal placeholder contact structures 801 will eventually be replaced by backside contacts while metal placeholder structures 2303 remain in the fabricated transistor structure.

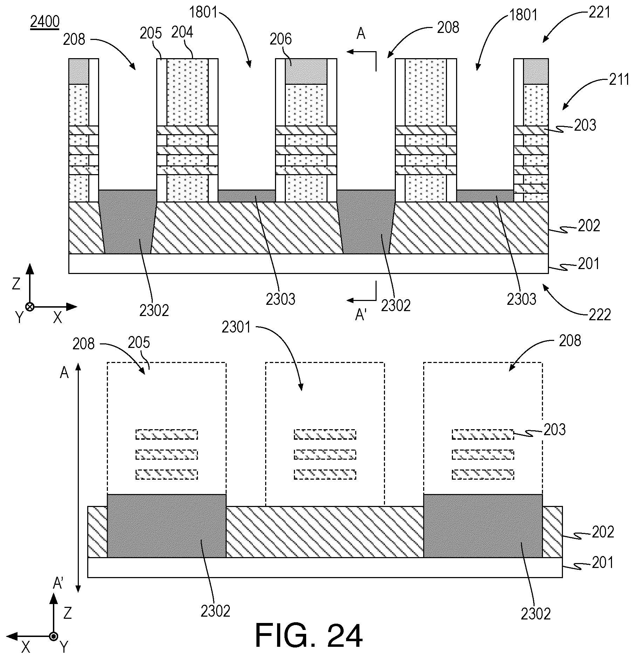

FIG. 24 illustrates a cross-sectional side view of a transistor structure 2400 similar to transistor structure 2300 after removal of sacrificial template 2001. Sacrificial template 2001 may be removed using any suitable technique or techniques such as selective wet etch techniques. Removal of sacrificial template 2001 leaves metal placeholder contact structures 2302 recessed within deep openings 208 and metal placeholder structures 2303 recessed within standard openings 1801.

Returning to FIG. 1, processing continues at operation 1707, where source and drain materials are grown from the exposed semiconductor materials. The source and drain semiconductor materials may be deposited using epitaxially growth processing, for example. Such source and drain materials may include any of those discussed herein with respect to operation 107, for example. Such source and drain structures may be characterized as impurity doped regions.

FIG. 25 illustrates a cross-sectional side view of a transistor structure 2500 similar to transistor structure 2400 after formation of source structures 1101 and drain structures 1102. Source structures 1101 and drain structures 1102 may be formed using any suitable technique or techniques such as vapor phase epitaxy techniques, molecular beam epitaxy techniques, or other epitaxial growth techniques. Source structures 1101 and drain structures 1102 may include any material(s) and may have any characteristics discussed herein with respect to FIG. 11.

Returning to FIG. 17, processing continues at operation 1708, where gate structures are formed, frontside contacts are made, and frontside metallization layers are fabricated. Such processing may be performed using any suitable technique or techniques discussed herein above with respect to operation 108. For example, dummy gate materials are replaced with gate structures, source and/or drain structures and the gate structures are contacted by metal contacts, and frontside metallization layers may be formed over (and selectively coupled to) the frontside contacts.

FIG. 26 illustrates a cross-sectional side view of a transistor structure 2600 similar to transistor structure 2500 after formation of gate structures 1204, drain contact 1207, gate contact 1205, and dielectric material 1206. As discussed above, gate structures 1204 include gate dielectric 1203 separating gate electrodes 1202 from channel regions 1201 of semiconductor structures 203. Gate structures 1204 (inclusive of gate dielectric 1203 and gate electrodes 1202), drain contact 1207, gate contact 1205, and dielectric material 1206 may be formed using any techniques and may have any characteristics discussed herein.

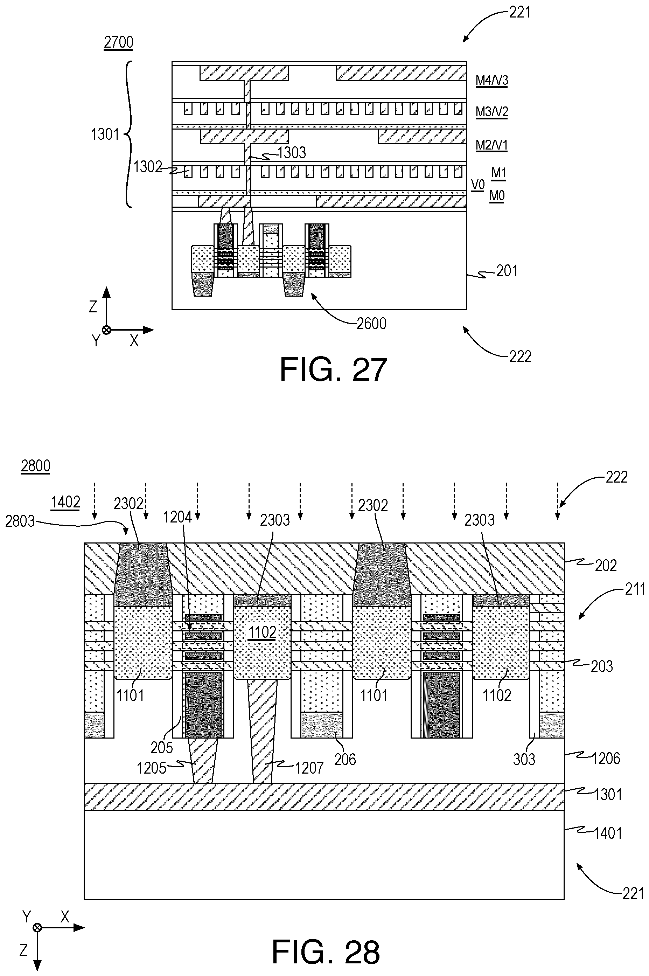

FIG. 27 illustrates a cross-sectional side view of a transistor structure 2700 similar to transistor structure 2600 after formation of frontside metallization layers 1301 (or frontside interconnect layers), which may be formed using any suitable technique or techniques such as dual damascene techniques, single damascene techniques, subtractive metallization patterning techniques, or the like. Frontside metallization layers 1301 provide interconnectivity, signal routing, power-delivery, and the like and frontside metallization layers 1301 may have any characteristics discussed above.

Returning to FIG. 17, processing continues at operation 1709, where the partially fabricated workpiece is mounted, by its frontside, to a carrier such as a carrier wafer, and the backside contact sacrificial material is exposed through the backside of the substrate of the workpiece. The workpiece may be mounted to the carrier using any suitable technique or techniques and the backside contact sacrificial material is then exposed by, for example, backside grind, backside etch, or the like.

FIG. 28 illustrates a cross-sectional side view of a transistor structure 2800 similar to transistor structure 2700 after attachment to carrier 1401, and backside substrate removal processing 1402 to expose a backside surface 2803 of metal placeholder contact structures 2302. Substrate removal processing 1402 may include backside grind (e.g., backside planarization) or backside etch processing that thins substrate 201 and/or subfins 202 in a planar fashion to expose instances of metal placeholder contact structures 2302 for backside contact processing.

Returning to FIG. 17, processing continues at operation 1710, where a backside contact is formed by replacement of the backside contact metal placeholder material formed at operation 1705, and after backside metallization layers are fabricated. Such processing may be performed using any suitable technique or techniques. In some embodiments, the backside contact metal placeholder material is removed using selective etch processing and replaced with backside contact metal using deposition and planarization techniques. Furthermore, backside metallization layers may be formed over (and selectively coupled to) the backside contacts using any suitable technique or techniques such as dual damascene techniques, single damascene techniques, subtractive metallization patterning techniques, or the like.

Processing continues at operation 1711, where the carrier is removed using any suitable technique or techniques, and at operation 1712, where continued processing is performed as is known in the art. Such processing may include dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

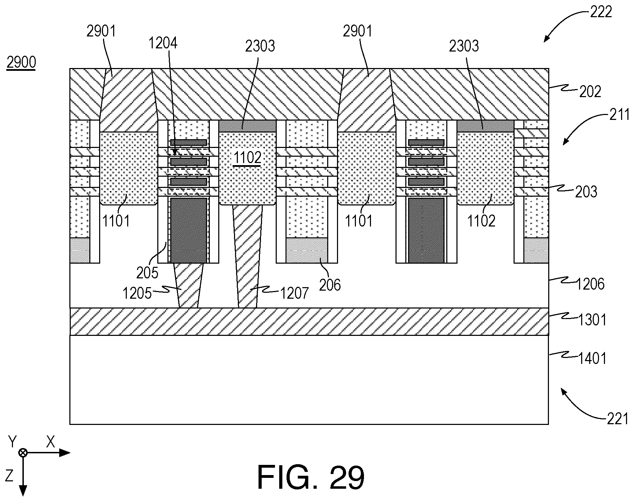

FIG. 29 illustrates a cross-sectional side view of a transistor structure 2900 similar to transistor structure 2800 after removal metal placeholder contact structures 2302, and formation of backside contacts 2901 (e.g., backside contact metal). For example, metal placeholder contact structures 2302may be removed using selective etch techniques and the resultant contact hole may be filled by metal backside contacts 2901 using deposition and planarization techniques. Backside contacts 2901 may include any suitable materials for contacting source structures 1101 (and/or drain structures 1102). In addition to the bulk material of backside contacts 2901, backside contacts 2901 may include a silicide layer or other chemical compound layer (not shown) formed on backside surfaces of source structures 1101 and/or drain structures 1102 prior to formation of the bulk material of backside contacts 2901. Such materials may reduce the contact resistance to source structures 1101 and/or drain structures 1102. The silicide layer or other chemical compound layer and the bulk material of backside contact 1501 may be formed using any suitable technique or techniques. For example, the silicide layer or other chemical compound layer may be formed by application of a thin layer (e.g., titanium, nickel, sodium, magnesium, platinum, tungsten, molybdenum, etc.) followed by an anneal process. Subsequently, the fill metal of backside contact 1501 may be deposited and planarized. In some embodiments, a layer of titanium nitride (e.g., a layer including titanium and nitrogen is first formed). The fill metal of backside contact 1501 may be any suitable contact metal such as molybdenum, tungsten, cobalt, a combination thereof, or other metal(s).

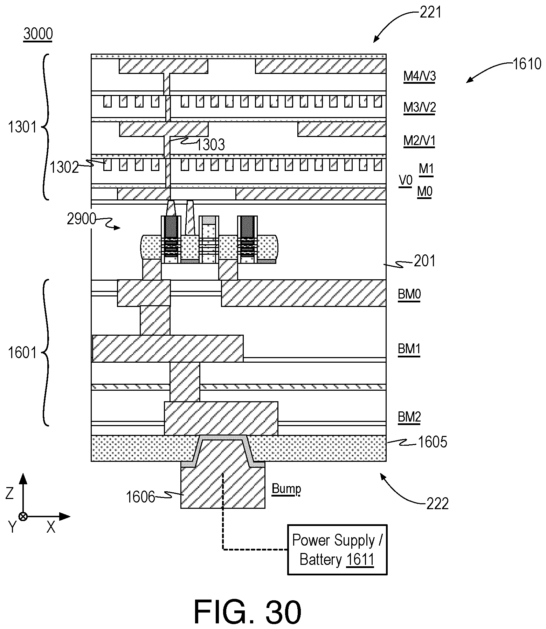

FIG. 30 illustrates a cross-sectional side view of a transistor structure 3000 similar to transistor structure 2900 after formation of backside metallization layers 1601 (or backside interconnect layers). The view of FIG. 30 is inverted with respect to that of FIG. 29. Backside metallization layers 1601 may be formed using any suitable technique or techniques and may have any characteristics discussed herein above. In some embodiments, transistor structure 3000 is deployed in a monolithic integrated circuit (IC) die 1610 including a GAA transistor structure (e.g., a GAA-FET), the transistor structure including any of the discussed components and characteristics. As shown, a power supply 1611 may be coupled to IC die 1610, such that power supply 1611 may include a battery, voltage converter, power supply circuitry, or the like.

With reference to FIGS. 29 and 30, transistor structure 3000 includes one or more frontside metallization layers 1301 and one or more backside metallization layers 1601. Transistor structure 2900 (or any other transistor structure discussed herein) includes semiconductor structures 203 between and coupling first and second impurity doped regions (i.e., source and drain structures 1101, 1102), and gate electrodes 1202 adjacent semiconductor structures 203 such that transistor structure 2900 is between frontside metallization layers 1301 and backside metallization layers 1601. Transistor structure 3000 includes backside contact 2901 coupled to a first impurity doped region (one of source and drain structures 1101, 1102) and backside metallization layers 1601, and further includes metal placeholder structure 2303 between a second impurity doped region (one of source and drain structures 1101, 1102) and backside metallization layers 1601, such metal placeholder structure 2303 is in contact with the second impurity doped region and decoupled from backside metallization layers 1601. As used herein the term decoupled indicates a metallization structure or feature is insulated from and cannot provide electrical signal, routing, power or the like to the decoupled structure. As discussed, metal placeholder structure 2303 is isolated from backside contact due to being formed in one of standard openings 1801 instead of one of deep openings 208.

In some embodiments, metal placeholder structure 2303 is or includes tungsten. In some embodiments, metal placeholder structure 2303 includes a liner (not shown) on the second impurity doped region such that the liner includes titanium and nitrogen (e.g., is titanium nitride), as discussed with respect to FIG. 22. In some embodiments, backside contact 2901 includes a silicide at an interface with the first impurity doped region, the silicide including one of titanium, nickel, sodium, magnesium, platinum, tungsten, or molybdenum. In some embodiments, backside contact 2901 includes a first metal and includes a second, different metal. In some embodiments, the first metal of backside contact 2901 is one of titanium, nickel, sodium, magnesium, platinum, molybdenum, or cobalt, and the second metal is tungsten.

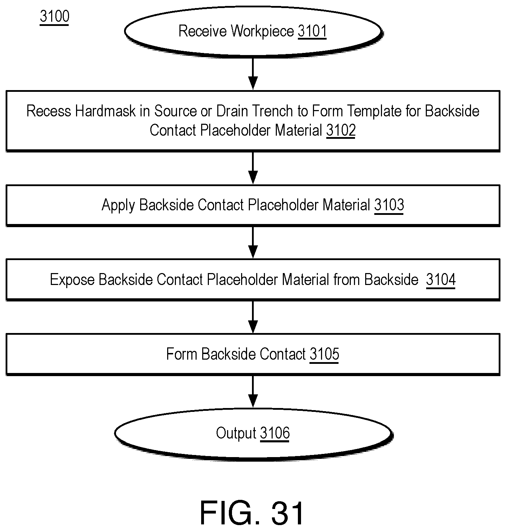

FIG. 31 is a flow diagram illustrating methods 3100 for forming a backside contact placeholder with improved process control, and replacement of the placeholder with a backside contact, arranged in accordance with at least some implementations of the present disclosure.

Methods 3100 begin at input operation 3101, where a workpiece is received. For example, a partially formed transistor structure formed over a substrate may be received for processing. The received substrate may include any suitable material or materials in any format. For example, the substrate may be a monocrystalline silicon wafer or the like. The partially formed transistor structure includes one or more semiconductor structures that are vertically aligned or stacked. These semiconductor structures may be silicon (Si), germanium (Ge), silicon germanium (SiGe), III-V materials (e.g., gallium arsenide (GaAs)), or other semiconductor materials such as transition metal dichalcogenide (TMD) materials. As used herein, the term semiconductor material indicates a material with a variable conductivity that may be manipulated for use as a channel material in a transistor. The semiconductor structures further include either a gate coupled to the semiconductor structures or a dummy gate in a position for later replacement by gate structures. The semiconductor structures are interleaved with and surrounded by the gates or dummy gates and the gates or dummy gates are contained by a dielectric spacer.

Processing continues at operation 3102, where a hardmask material is recessed in a deep source or drain trench adjacent the semiconductor structures to form a template for a backside contact placeholder material. In some embodiments, an opening is first formed adjacent the semiconductor structures such that the opening is a deep opening that extends below the semiconductor structures into the substrate to a distance that the deep opening may be accessed from a backside of the transistor structure. The deep opening may then be filled with in insulator material such as a carbon hardmask material. The insulator material (e.g., carbon hardmask material) is then recessed to a position below the semiconductor structures such that a portion of the insulator material remains at a depth desirable for an eventual backside contact. This forms a template for a backside contact placeholder material.

Processing continues at operation 3103, where the template formed by insulator material recess processing is replaced to form a backside contact placeholder material. In some embodiments, using the insulator material as a template to form the backside contact placeholder material includes exposing a portion of a seed liner under the recessed insulator material, and forming the backside contact placeholder material on the exposed seed liner as shown with respect to FIGS. 3 to 9. In some embodiments, such processing includes forming a first liner (e.g., liner 301) in the opening (e.g., deep opening 208) prior to said filling the opening with the insulator material (e.g., fill material 401) and recessing the insulator material (e.g., to form placeholder contact structure 501) and forming a second liner (e.g., liner 601) on exposed portions of the first liner and a top surface of the recessed insulator material, such that replacing the template of the insulator material with the placeholder metal includes removing the recessed insulator material (e.g., placeholder contact structure 501) and a portion of the second liner, and selectively growing the placeholder metal (metal placeholder contact structure 801) from the first liner.

In some embodiments, using the insulator material as a template to form the backside contact placeholder material includes forming a confined void and filling the void as discussed with respect to FIGS. 19 to 24. In some embodiments, such processing includes filling the opening over the recessed insulator material (e.g., regions 1901a of patterned hardmask 1901) with a second material (e.g., sacrificial template 2001), selectively removing the insulator material to form a second opening (e.g., void 2101a), filling the second opening with the placeholder metal (e.g., regions 2201 of metal placeholder contact materials 2201), and removing the second material.

Processing continues at operation 3104, where the contact placeholder material is exposed from the backside as discussed with respect to FIGS. 14 and 29, and at operation 3105, where the backside contact placeholder material is removed and a backside contact is formed in the opening as discussed with respect to FIGS. 15 and 30. Processing continues at operation 3106, where the resultant transistor structure is processed inclusive of dicing, packaging, assembly, and so on, for deployment in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

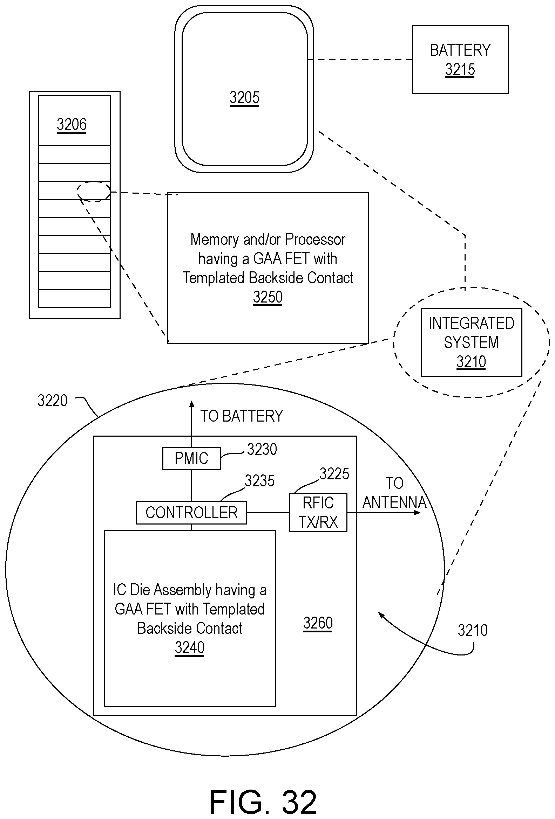

FIG. 32 illustrates exemplary systems employing transistor structures having a templated backside contact coupled to a source and/or drain structures of the transistor structures, in accordance with some embodiments. The system may be a mobile computing platform 3205 and/or a data server machine 3206, for example. Either may employ a monolithic IC die, for example, including transistor structures having a templated backside contact coupled to a source and/or drain structures of the transistor structures (e.g., a backside contact that replaced a backside placeholder metal templated from a recessed hardmask material) as described elsewhere herein. Server machine 3206 may be any commercial server, for example including any number of high-performance computing platforms disposed within a rack and networked together for electronic data processing, which in the exemplary embodiment includes an IC die assembly 3250 including transistor structures having a templated backside contact coupled to a source and/or drain structures of the transistor structures as described elsewhere herein. Mobile computing platform 3205 may be any portable device configured for each of electronic data display, electronic data processing, wireless electronic data transmission, or the like. For example, mobile computing platform 3205 may be any of a tablet, a smart phone, a laptop computer, etc., and may include a display screen (e.g., a capacitive, inductive, resistive, or optical touchscreen), a chip-level or package-level integrated system 3210, and a battery/power supply 3215. Although illustrated with respect to mobile computing platform 3205, in other examples, chip-level or package-level integrated system 3210 and a battery/power supply 3215 may be implemented in a desktop computing platform, an automotive computing platform, an internet of things platform, or the like. As discussed below, in some examples, the disclosed systems may include a sub-system 3260 such as a system on a chip (SOC) or an integrated system of multiple ICs, which is illustrated with respect to mobile computing platform 3205.

Whether disposed within integrated system 3210 illustrated in expanded view 3220 or as a stand-alone packaged device within data server machine 3206, sub-system 3260 may include memory circuitry and/or processor circuitry 3240 (e.g., RAM, a microprocessor, a multi-core microprocessor, graphics processor, etc.), a power management integrated circuit (PMIC) 3230, a controller 3235, and a radio frequency integrated circuit (RFIC) 3225 (e.g., including a wideband RF transmitter and/or receiver (TX/RX)). As shown, one or more IC dice, such as memory circuitry and/or processor circuitry 3240 may be assembled and implemented such that one or more have transistor structures including a templated backside contact coupled to a source and/or drain structures of the transistor structures as described herein. In some embodiments, RFIC 3225 includes a digital baseband and an analog front end module further comprising a power amplifier on a transmit path and a low noise amplifier on a receive path). Functionally, PMIC 3230 may perform battery power regulation, DC-to-DC conversion, etc., and so has an input coupled to battery/power supply 3215, and an output providing a current supply to other functional modules. As further illustrated in FIG. 32, in the exemplary embodiment, RFIC 3225 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 3240 may provide memory functionality for sub-system 3260, high level control, data processing and the like for sub-system 3260. In alternative implementations, each of the SOC modules may be integrated onto separate ICs coupled to a package substrate, interposer, or board.

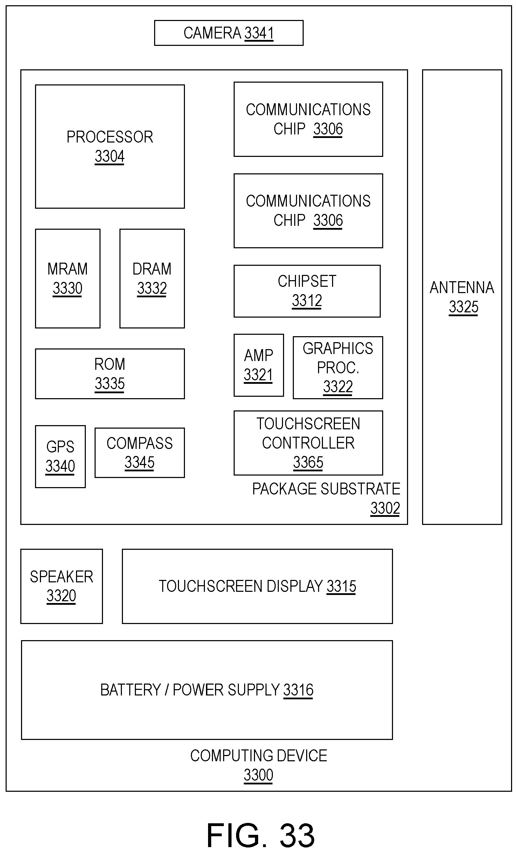

FIG. 33 is a functional block diagram of an electronic computing device 3300, in accordance with some embodiments. For example, device 3300 may, via any suitable component therein, implement transistor structures having a templated backside contact coupled to a source and/or drain structures of the transistor structures as discussed herein. For example, one or more IC dies of electronic computing device 3300 may deploy transistor structures having a templated backside contact coupled to a source and/or drain structures of the transistor structures as described herein. Device 3300 further includes a motherboard or package substrate 3302 hosting a number of components, such as, but not limited to, a processor 3304 (e.g., an applications processor). Processor 3304 may be physically and/or electrically coupled to package substrate 3302. In some examples, processor 3304 is within an IC assembly. In general, the term "processor" or "microprocessor" may refer to any device or portion of a device that processes electronic data from registers and/or memory to transform that electronic data into other electronic data that may be further stored in registers and/or memory.

In various examples, one or more communication chips 3306 may also be physically and/or electrically coupled to the package substrate 3302. In further implementations, communication chips 3306 may be part of processor 3304. Depending on its applications, computing device 3300 may include other components that may or may not be physically and electrically coupled to package substrate 3302. These other components include, but are not limited to, volatile memory (e.g., DRAM 3332), non-volatile memory (e.g., ROM 3335), flash memory (e.g., NAND or NOR), magnetic memory (MRAM 3330), a graphics processor 3322, a digital signal processor, a crypto processor, a chipset 3312, an antenna 3325, touchscreen display 3315, touchscreen controller 3365, battery/power supply 3316, audio codec, video codec, power amplifier 3321, global positioning system (GPS) device 3340, compass 3345, accelerometer, gyroscope, speaker 3320, camera 3341, and mass storage device (such as hard disk drive, solid-state drive (SSD), compact disk (CD), digital versatile disk (DVD), and so forth, or the like.

Communication chips 3306 may enable wireless communications for the transfer of data to and from the computing device 3300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 3306 may implement any of a number of wireless standards or protocols, including, but not limited to, those described elsewhere herein. As discussed, computing device 3300 may include a plurality of communication chips 3306. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others. Battery/power supply 3316 may include any suitable power supply circuitry and, optionally, a battery source to provide power to components of electronic computing device 3300.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described but can be practiced with modification and alteration without departing from the scope of the appended claims. For example, the above embodiments may include specific combinations of features as further provided below.

The following pertains to exemplary embodiments.

In one or more first embodiments, an apparatus comprises a frontside metallization layer and a backside metallization layer, a transistor structure comprising one or more semiconductor structures between and coupling first and second impurity doped regions, and a gate electrode adjacent the semiconductor structures, wherein the transistor structure is between the frontside metallization layer and a backside metallization layer, and a backside contact coupled to the first impurity doped region and the backside metallization layer, the backside contact comprising a convex surface on the first impurity doped region.

In one or more second embodiments, further to the first embodiments, the convex surface comprises an apex, and wherein a vector normal to the convex surface at the apex is substantially orthogonal to the frontside metallization layer.

In one or more third embodiments, further to the first or second embodiments, the backside contact comprises a substantially flat surface adjoining the convex surface, the substantially flat surface extending from the convex surface to a lateral edge of the backside contact.

In one or more fourth embodiments, further to the first through third embodiments, a second vector normal to the substantially flat surface is substantially orthogonal to the frontside metallization layer.

In one or more fifth embodiments, further to the first through fourth embodiments, the first impurity doped region comprises a concave surface corresponding to the convex surface.

In one or more sixth embodiments, further to the first through fifth embodiments, the convex surface of the backside contact comprises titanium and nitrogen.

In one or more seventh embodiments, further to the first through sixth embodiments, the apparatus further comprises a frontside contact coupled to the second impurity doped region and the frontside metallization layer.

In one or more eighth embodiments, further to the first through seventh embodiments, an integrated circuit (IC) die comprises the frontside metallization layer, the backside metallization layer, the transistor structure, and the backside contact, and the apparatus further comprises a power supply coupled to the IC die.

In one or more ninth embodiments, a system comprises an IC die including an apparatus according to any of the apparatuses of the first through eighth embodiments, the system further including a power supply or display coupled to the IC die.

In one or more tenth embodiments, an apparatus comprises a frontside metallization layer and a backside metallization layer, a transistor structure comprising one or more semiconductor structures between and coupling first and second impurity doped regions, and a gate electrode adjacent the semiconductor structures, wherein the transistor structure is between the frontside metallization layer and a backside metallization layer, a backside contact coupled to the first impurity doped region and the backside metallization layer, and a metal structure between the second impurity doped region and the backside metallization layer, the metal structure in contact with the second impurity doped region and decoupled from the backside metallization layer.

In one or more eleventh embodiments, further to the tenth embodiments, the metal structure comprises tungsten.

In one or more twelfth embodiments, further to the tenth or eleventh embodiments, the metal structure further comprises a liner on the second impurity doped region, the liner comprising titanium and nitrogen.

In one or more thirteenth embodiments, further to the tenth through twelfth embodiments, the backside contact comprises a silicide at an interface with the first impurity doped region, the silicide comprising one of titanium, nickel, sodium, magnesium, platinum, tungsten, or molybdenum.

In one or more fourteenth embodiments, further to the tenth through thirteenth embodiments, the backside contact comprises a first metal and the metal structure comprising a second metal.

In one or more fifteenth embodiments, further to the tenth through fourteenth embodiments, the first metal is one of titanium, nickel, sodium, magnesium, platinum, molybdenum, or cobalt, and the second metal is tungsten.

In one or more sixteenth embodiments, further to the tenth through fifteenth embodiments, the apparatus further comprises a frontside contact coupled to the second impurity doped region and the frontside metallization layer.

In one or more seventeenth embodiments, further to the tenth through sixteenth embodiments, an integrated circuit (IC) die comprises the frontside metallization layer, the backside metallization layer, the transistor structure, the backside contact, and the metal structure, and the apparatus further comprises a power supply coupled to the IC die.

In one or more eighteenth embodiments, a system comprises an IC die including an apparatus according to any of the apparatuses of the tenth through seventeenth embodiments, the system further including a power supply or display coupled to the IC die.

In one or more nineteenth embodiments, a method comprises forming an opening adjacent to expose a stack of nanoribbons, wherein the stack of nanoribbons is over a substrate and wherein the opening extends into the substrate, filling the opening with an insulator material, recessing the insulator material to a position below the stack of nanoribbons to form a template comprising the insulator material, replacing the template comprising the insulator material with a placeholder metal, growing an impurity doped region from the exposed stack of nanoribbons, the impurity doped region on the placeholder metal, and replacing the placeholder metal with a backside contact.

In one or more twentieth embodiments, further to the nineteenth embodiments, the insulator material comprises a carbon hardmask material, the placeholder metal comprises tungsten, and the backside contact comprises a silicide at an interface with the impurity doped region.

In one or more twenty-first embodiments, further to the nineteenth or twentieth embodiments, the method further comprises forming a first liner in the opening prior to said filling the opening with the insulator material and said recessing the insulator material, and forming a second liner on exposed portions of the first liner and a top surface of the recessed insulator material, wherein replacing the template comprising the insulator material with the placeholder metal comprises removing the recessed insulator material and a portion of the second liner, and selectively growing the placeholder metal from the first liner.

In one or more twenty-second embodiments, further to the nineteenth through twenty-first embodiments, replacing the template comprising the insulator material with the placeholder metal comprises filling the opening with a second material, selectively removing the insulator material to form a second opening, filling the second opening with the placeholder metal, and removing the second material.

It will be recognized that the invention is not limited to the embodiments so described but can be practiced with modification and alteration without departing from the scope of the appended claims. For example, the above embodiments may include specific combination of features. However, the above embodiments are not limited in this regard, and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a frontside metallization layer and a backside metallization layer;
a transistor structure comprising one or more semiconductor structures between and coupling first and second
impurity doped regions, and a gate electrode adjacent the semiconductor structures, wherein the
transistor structure is between the frontside metallization layer and a backside metallization layer; and a backside contact coupled to the first impurity doped region and the backside metallization layer, the backside
contact comprising a convex surface on the first impurity doped region.

2. The apparatus of claim 1, wherein the convex surface comprises an apex, and wherein a vector normal to the convex surface at the apex is substantially orthogonal to the frontside metallization layer.

3. The apparatus of claim 1 or 2, wherein the backside contact comprises a substantially flat surface adjoining the convex surface, the substantially flat surface extending from the convex surface to a lateral edge of the backside contact.

4. The apparatus of claim 3, wherein a second vector normal to the substantially flat surface is substantially orthogonal to the frontside metallization layer.

5. The apparatus of any of claims 1 to 4, wherein the first impurity doped region comprises a concave surface corresponding to the convex surface.

6. The apparatus of any of claims 1 to 5, wherein the convex surface of the backside contact comprises titanium and nitrogen.

7. The apparatus of any of claims 1 to 6, further comprising a frontside contact coupled to the second impurity doped region and the frontside metallization layer.

8. The apparatus of any of claims 1 to 7, wherein an integrated circuit (IC) die comprises the frontside metallization layer, the backside metallization layer, the transistor structure, and the backside contact, the apparatus further comprising a power supply coupled to the IC die.

9. A method, comprising:
forming an opening to expose a stack of nanoribbons, wherein the stack of nanoribbons is over a substrate and wherein the opening extends into the substrate;
filling the opening with an insulator material;
recessing the insulator material to a position below the stack of nanoribbons to form a template comprising the insulator material;
replacing the template comprising the insulator material with a placeholder metal;
growing an impurity doped region from the exposed stack of nanoribbons, the impurity doped region on the placeholder metal; and
replacing the placeholder metal with a backside contact.

10. The method of claim 9, wherein the insulator material comprises a carbon hardmask material.

11. The method of claim 9 or 10, wherein the placeholder metal comprises tungsten.

12. The method of any of claims 9 to 11, wherein the backside contact comprises a silicide at an interface with the impurity doped region.

13. The method of claim 12, wherein the silicide comprises one of titanium, nickel, sodium, magnesium, platinum, tungsten, or molybdenum.

14. The method of any of claims 9 to 13, further comprising:
forming a first liner in the opening prior to said filling the opening with the insulator material and said recessing the insulator material; and
forming a second liner on exposed portions of the first liner and a top surface of the recessed insulator material, wherein replacing the template comprising the insulator material with the placeholder metal comprises:
removing the recessed insulator material and a portion of the second liner; and
selectively growing the placeholder metal from the first liner.

15. The method of any of claims 9 to 14, wherein replacing the template comprising the insulator material with the placeholder metal comprises:
filling the opening with a second material;
selectively removing the insulator material to form a second opening;
filling the second opening with the placeholder metal; and
removing the second material.
